# EUROPEAN PATENT APPLICATION

(11) **EP 2 535 768 A1**
(43) Date of publication of application: **19.12.2012**
(21) Application number: 11741987.9
(22) Date of filing: 18.01.2011
(51) Int. Cl.: G03F 7/11, H01L 21/027, H01L 21/3065

(54) **UNDERLAYER FILM MATERIAL, AND METHOD FOR FORMATION OF MULTILAYER RESIST PATTERN**

(30) Priority: 12.02.2010 JP 2010028775
(71) Applicant: Mitsubishi Gas Chemical Company, Inc., Tokyo 100-8324 (JP)
(72) Inventor: HAYASHI, Hiromi, Hiratsuka-shi Kanagawa 254-0016 (JP); ECHIGO, Masatoshi, Hiratsuka-shi Kanagawa 254-0016 (JP)
(74) Representative: HOFFMANN EITLE
(86) International application number: PCT/JP2011/000228
(87) International publication number: WO 2011/099235

(57) **Abstract**

This invention is intended to provide an underlayer film material for forming a resist underlayer film, which has a high solubility in safety solvents, an excellent etching resistance and substantially no sublimate, and a method of forming a resist pattern using the same.

This invention is characterized by an underlayer film material comprising two or more cyclic compounds having a particular structure, and a method of forming a resist pattern using the underlayer film material.

## Description

### TECHNICAL FIELD

This invention relates to an underlayer film material which is effective in a multilayer resist step used for microfabrication in a producing step of a semiconductor device and the like. Also, this invention relates to a method of forming a resist pattern suitable for exposing far ultraviolet rays, KrF excimer laser light (248 nm), ArF excimer laser light (193 nm), F₂ laser light (157 nm), K₂ laser light (146 nm), Ar₂ laser light (126 nm), soft X-rays, electron beams, ion beams and X-rays with the under film coat material.

### BACKGROUND ART

Recently, as refinement of pattern rule is needed with high integration and speeding up of LSI, lithography using exposure to light currently employed as general-purpose technology is approaching the limit of substantive resolution derived from a wavelength of light source.

Exposure to light is widely used, which employs a g-line (436 nm) or i-line (365 nm) of a mercury lamp as a light source for lithography used during resist pattern formation, and a method of shortening a wavelength of exposing light has been considered to be effective as a means for further refinement. For this reason, KrF excimer laser (248 nm) having short wavelength was utilized instead of i-line (365 nm) as an exposing light source in mass production processes for 64M bits DRAM processing method. But in manufacture of DRAM having a degree of integration of 1 G bits or more requiring more refined processing technique (processed dimensions of 0.13 µm or less), a light source having a shorter wavelength was needed, and particularly, lithodraphy using ArF excimer laser (193 nm) has been studied. However, various problems have arised with refinement.

One of such big problems is the aspect ratio. ArF resist has a relatively small etching resistance and is needed to increase its aspect ratio, though the aspect ratio cannot be increased because of collapse of resist pattern. So, three-layer resist process is known as a measn of forming a pattern of a high aspect ratio, wherein an underlayer film material (forming material of a base sheet) is applied on a substrate and heated to form a film, thereby setting up an underlayer film, thereon an intermediate film consisting of a silica based inorganic film is set up, further thereon a photoresist film is set up, a resist pattern is formed by an usual photolithograpy technique, and the pattern is transferred by eching the intermediate film with the resist pattern as a mask, and then the under coat layer is oxygen plasma etched with the patterned intermediated film as a mask to form a pattern on the substrate.

Two-layer resist process superior in terms of fewer number of steps than that of three-layer resist process has been also proposed. In a two-layer resit process, an underlayer film is set up on a substrate as with a three-layer resist process, and then a photoresist film containing a silicon-containing polymer is set up as their upper layer to form a resist pattern by an usual usual photolithograpy technique, etching by oxygen plasma is performed with the resist pattern as a mask to transfer the resist pattern to the underlayer film. Eching by fluorocarbon based gas and the like is performed with the resist pattern as a mask to form a pattern on the substrate.

Here, as an underlayer film material for 193 nm, copolymers of polyhydroxystyrene and acrylic acid ester is generatly studied. Polyhydroxystyrene has a very strong absorption at 193 nm whose extinction coefficient (k) by itself is high value of around 0.6. So, the k value is adjusted to around 0.25 by copolymerizing with acrylic acid ester whose k value is almost 0.

However, etching resistance of acrylic acid ester in substrat etching is weak compared to polyhydroxystyrene, furthermore acrylic acid ester has to be copolymerized in a high position in order to decrease the k value, and consequently it results in decreased resistance in substance etching. Since resistance in etching appears as an etching rate as well as generation of surface roughness after etching, increased surface roughness after etching after etching by copolymerization of acrylic acid ester becomes a serious problem.

Naphthalene ring is one of those have a high transparency at 193 nm and a higer etching resistance than benzene ring, and an underlayer film having a naphthalene ring or an anthracene ring is proposed (Patent Document 1). However, naphthol cocondensed novolak resins and polyvinylnaphthalene resins have a k value of between 0.3 and 0.4 and do not achieve the targeted transparency of a k value of 0.1 to 0.3, and the transparency must be further increased. Also, acenaphthylene polymers (Patent Documents 2 and 3) have a low reflactive index (n) and high k value at a wavelength of 193 nm compered with that at a wavelength of 248 nm, both of which have not achieved the targeted levels. In addition, an underlayer film obtained by adding an acryl resin to a naphtol cocondensed novolak resin (Patent Document 4) and an underlayer film consisting of a high molecular weight compound formed by copolymerizing indene with a compound having both a hydroxyl group or epoxy group and a double bond (Patent Document 5) are disclosed, but these have not achieved a k of 0.1 to 0.3 which is the required value.

Furthermore, in under coat materials, the other problem is a sublimation component. It has become a big problem that a sublimate forms crystals on the surface of upper plate when baking and the crystals fall on a wafer, which becomes a cause of defects. For such reason, a material containing a less sublimate has been required. In conventional materials, high molecular weight polymers such as nobolak-based resin and the like are used due to demands for etching resistance, but the polymers comprise monomer, nonreacted dimer and oligomer components having sublimability, eliminating the sublimation components increases number of steps and has a huge effect on manufacturing costs.

Thus, it requires an under coat material which has a high n value and low k value, is tansparent and high in etching resistance, and further comprises an extremely less sublimation component, and the inventors have already proposed calixresorcinarene compound as such material. However, its solubility in a coating solvent is low and its etching resistance is insufficient even though its n and k values are good, and further improvenent of under coat materials has been desired.

### RELATED PATENT DOCUMENTS

Patent Document 1: JP-A-2002-14474
Patent Document 2: JP-A-2001-40293
Patent Document 3: JP-A-2002-214777
Patent Document 4: JP-A-2005-156816
Patent Document 5: JP-A-2006-53543
Patent Document 6: JP-A-2008-116677

### SUMMARY OF THE INVENTION

### PROBLEM TO BE SOLVED BY THE INVENTION

It is an problem to be solved by the invention to provide a composition (underlayer film material) for forming a novel photoresist underlayer film which is specially excel in the solbility in safety solvents and the etching resistance and furthermore has substantially no sublimate an underlayer film for two-layer or three-layer resist process, an underlayer film formed therefrom, and a method of forming a resist pattern using the same.

### MEANS FOR SOLVING PROBLEM

The inventors have devoted themselves to study for achiving the above objects and found out that an underlayer film forming composition comprising a polyphenol compound (1) represented by the following formula is a promising material as an underlayer film for two-layer or three-layer resist process, which is excel in the optical property and the etching resistance and furthermore has substantially no sublimate, and as a result, the invention has been accomplished.
Namely, the invention is as follows.
1. An underlayer film material comprising two or more cyclic compounds represented by the following formula (1-1), wherein at least one R' is a group represented by the following formula (1-2), and a content of at least one group represented by the formula (1-2) is 10 mol% to 90 mol% of R' contained in the material: 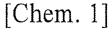 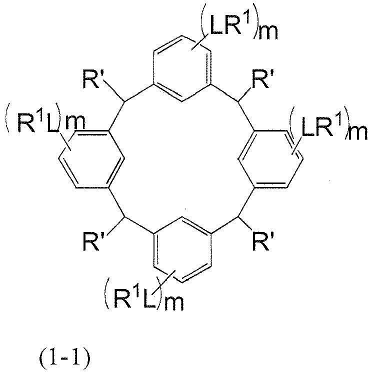 (in the formula (1-1), L is independently a divalent group selected from the group consisting of a single bond, a linear or branched alkylene group having a carbon number of 1 to 20, a cycloalkylene group having a carbon number of 3 to 20, an arylene group having a carbon number of 6 to 24, -O-, -OC(=O)-, -OC(=O)O-, - N(R⁵)-C(=O)-, -N(R⁵)-C(=O)O-, -S-, -SO-, -SO₂-, and any combination thereof; R¹ is independently an alkyl group having a carbon number of 1 to 20, a cycloalkyl group having a carbon number of 3 to 20, an aryl group having a carbon number of 6 to 20, an alkoxyl group having a carbon number of 1 to 20, a cyano group, a nitro group, a hydroxyl group, a heterocyclic group, a halogen atom, a carboxyl group, an acyl group having a carbon number of 2 to 20, an alkylsilyl group having a carbon number of 1 to 20, or a hydrogen atom; R' is independently a hydrogen atom, an alkyl group having a carbon number of 1 to 20, a biphenyl group, a group which is an aryl group having a carbon number of 6 to 20 substituted an alkyl group having a carbon number of 1 to 20 and a halogen atom for hydrogen atoms or which is an alkyl group having a carbon number of 2 to 20 substituted an alkyl group having a carbon number of 1 to 20 for one or more hydrogen atoms, an aryl group having a carbon number of 6 to 20, an alkoxy group having a carbon number of 1 to 20, a cyano group, a nitro group, a heterocyclic group, a halogen atom, a carboxyl group, an acyl group having a carbon number of 2 to 20, a hydroxyl group and an alkylsilyl group having a carbon number of 1 to 20, or a group represented by the following formula (1-2): 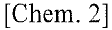 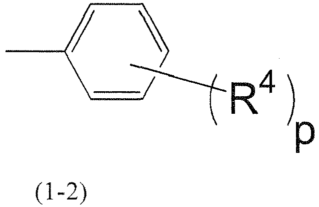 wherein, R⁴ is independently a functional group selected from the group consisting of a hydrogen atom, an alkyl group having a carbon number of 1 to 20, a cycloalkyl group having a carbon number of 3 to 20, an aryl group having a carbon number of 6 to 20, an alkoxy group having a carbon number of 1 to 20, a cyano group, a nitro group, a heterocyclic group, a halogen atom, a carboxyl group, a hydroxyl group, a cycloalkyl group having a alkyl group having a carbon number of 3 to 20, and an alkylsilyl group having a carbon number of 1 to 20; R5 is a hydrogen atom or an alkyl group having a carbon number of 1 to 10; m is an integer of 1 to 4; and, p is an integer of 0 to 5).
2. An underlayer film material according to claim 1, whrerein the cyclic compounds are represented by the following formula (2): 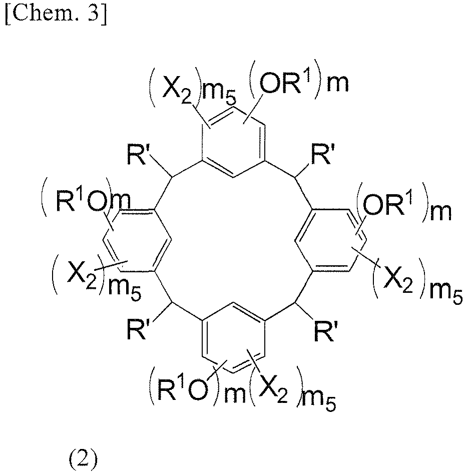 (in the formula (2), R¹, R' and m are the same as described above; X₂ is a hydrogen atom or a halogen atom; m₅ is an integer of 0 to 3; and, m + m₅ = 4).
3. An underlayer film material according to claim 1, wherein the cyclic compounds are represented by the following formula (3): 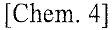 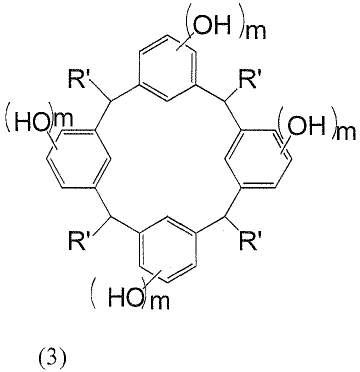 (in the formula (3), R' and m are the same as desdcribed above, with the proviso that all R' are not necessarily identical).
4. An underlayer film material according to claim 1, wherein R' comprises a group selected from the group consisting of groups represented by the following formulae (1-3), and all R' are not identical. 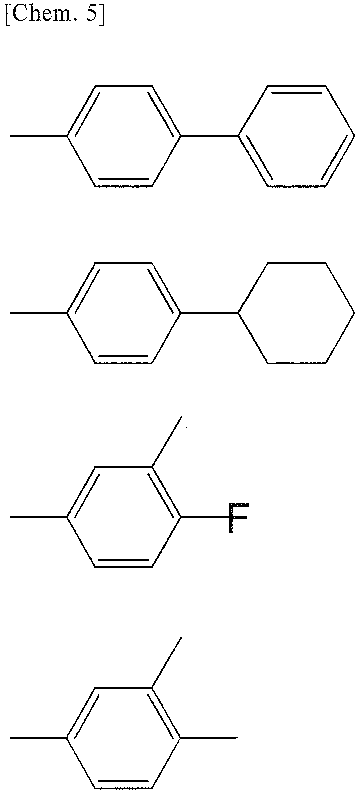 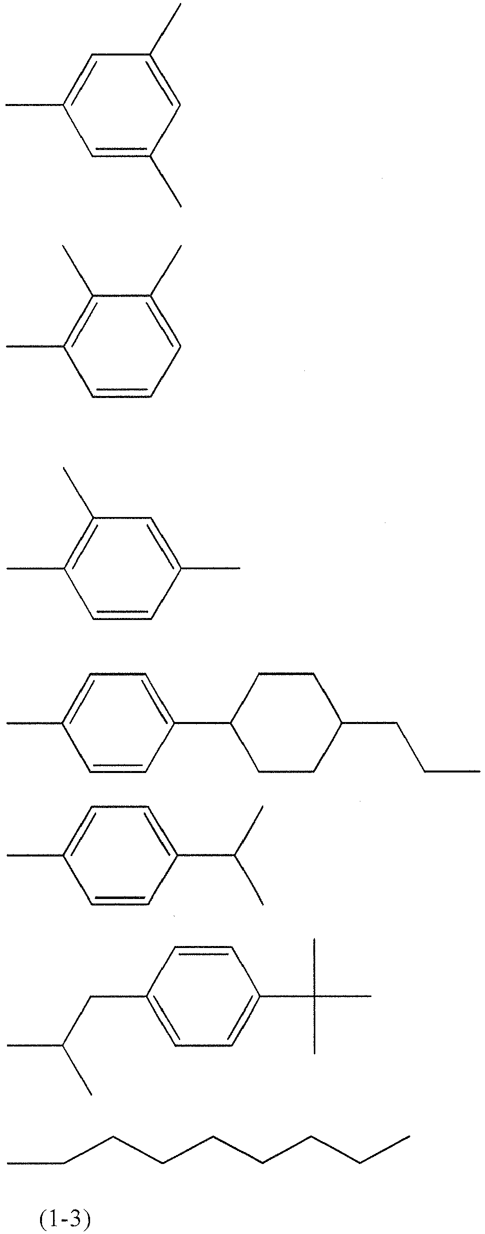
5. An underlayer film material according to claim 1, which is obtained by condensation reacting two or more selected from the group consisting of aldehydes (A1) represented by the following formula (4-1) (with the proviso that at least one is an aldehyde represented by the following formula (4-2)) and one or more selected from the group consisting of phenolic compounds (A2) by using an acid catalyst: 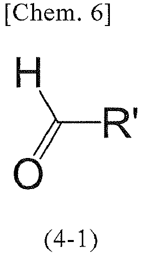 (in the formula (4-1), R' is the same as described above) 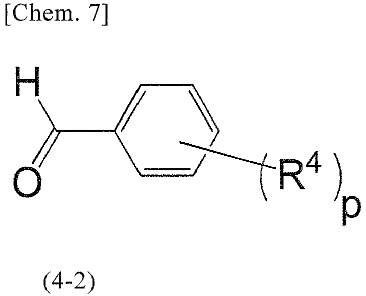 (in the formula (4-2), R⁴ and p are the same as described above).
6. An underlayer film material according to claim 5, which is obtained by dropping a mixed solution (B) consisting of the two or more selected from the group consisting of aldehydes (A1) (with the proviso that at least one is an aldehyde represented by the formula (4-2)) to a mixed solution (A) consisting of the phenolic compound (A2), the acid catalyst and an alcohol.
7. An underlayer film material according to claim 1, which further comprises a solvent.
8. An underlayer film material according to claim 1 or 7, wherein the cyclic compounds are cyclic compounds (A) having a molecular weight of 700 to 5000 and synthesized by condensation reaction of two or more selected from the group consisting of aldehydes (A1) represented by the following formula (4-1) (with the proviso that at least one is an aldehyde represented by the formula (4-2)) and one or more selected from the group consisting of phenolic compounds (A2) by using an acid catalyst: 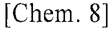 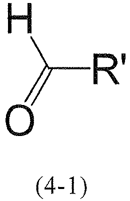 (in the formula (4-1), R' is the same as described above) 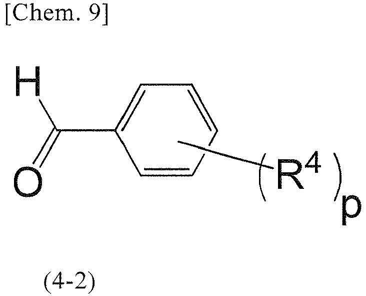 (in the formula (4-2), R⁴ and p are the same as described above).
9. An underlayer film material according to claim 8, which consists of 1 to 80 % by weight of a solid component and 20 to 99 % by weight of a solvent.
10. An underlayer film material according to claim 9, wherein the cyclic compounds (A) are 50 to 99.999 % by weight in the total weight of the solid component.
11. An underlayer film material according to claim 7, which further comprises an acid generator (C) directly or indirectly generating an acid by irradiation any radiation selected from the group consisting of visible light, ultraviolet ray, excimer laser, electron beams, extreme ultraviolet ray (EUV), X-ray and ion beams.
12. An underlayer film material according to claim 7, which further comprises an acid crosslinking agent (G).
13. An underlayer film material according to claim 7, which further comprises an acid-diffusion controller (E).
14. An underlayer film material according to claim 9, wherein the soild component comprises cyclic compound (A)/acid generator (C)/acid crosslinking agent (G)/acid-diffusion controller (E)/optional component (F) of 50-99.489/0.001-49.49/0.5-49.989/0.01-49.499/0-49.489 % by weight based on the solid component.
15. An underlayer film material according to claim 7, which is used in forming an amorphous film with spin coating.
16. An underlayer film formed with an underlayer film material according to any of claims 1 to 15.
17. A method of forming a resist pattern, comprising a step of forming an underlayer film on a substrate with the use of an underlayer film material according to any of claims 1 to 15, a step of exposing the underlayer film to radiation, and a step of developing a resist film made from the underlayer film to form a resist pattern.

### EFFECT OF THE INVENTION

By the method of forming a multi layer resist pattern using the underlayer film material according to the invention, it is capable of forming an underlayer film, which has a low reflectance with respect to a short-wavelength exposed light such as excimer laser light such as KrF, ArF and the like, and an excellent etching resistance to oxygen plasma etching and the like, and further surpresses pollution of an apparatus from a sublimate.

### MODE FOR CURRYING OUT THE INVENTION

The invention is described in more detail below.
[Underlayer film material comprising two or more cyclic compounds and method of producing the same]
The invention relates to a composition comprising cyclic compounds useful as an underlayer film material, and a method of producing the same.

The invention is an underlayer film material which comprises two or more cyclic compounds represented by the following formula (1-1) wherein at least one R is a group represented by the following formula (1-2), and a content of at least one group represented by the following formula (1-2) is 10 mol% to 90 mol% of R' contained in the material. 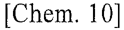 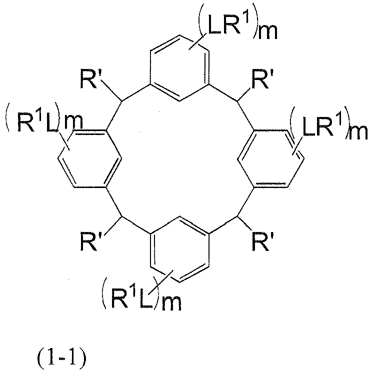 (In the formula (1-1), L is independently a divalent group selected from the group consisting of a single bond, a linear or branched alkylene group having a carbon number of 1 to 20, a cycloalkylene group having a carbon number of 3 to 20, an arylene group having a carbon number of 6 to 24, -O-, -OC(=O)-, - OC(=O)O-, -N(R⁵)-C(=O)-, -N(R⁵)-C(=O)O-, -S-, -SO-, -SO₂-, and any combination thereof, and R¹ is independently an alkyl group having a carbon number of 1 to 20, a cycloalkyl group having a carbon number of 3 to 20, an aryl group having a carbon number of 6 to 20, an alkoxyl group having a carbon number of 1 to 20, a cyano group, a nitro group, a hydroxyl group, a heterocyclic group, a halogen atom, a carboxyl group, an acyl group having a carbon number of 2 to 20, an alkylsilyl group having a carbon number of 1 to 20, or a hydrogen atom. R' is independently a hydrogen atom, an alkyl group having a carbon number of 1 to 20, a biphenyl group, a group which is an aryl group having a carbon number of 6 to 20 substituted an alkyl group having a carbon number of 1 to 20 and a halogen atom for hydrogen atoms or which is an alkyl group having a carbon number of 2 to 20 substituted an alkyl group having a carbon number of 1 to 20 for one or more hydrogen atoms, an aryl group having a carbon number of 6 to 20, an alkoxy group having a carbon number of 1 to 20, an aryl group having a carbon number of 6 to 20, an alkoxy group having a carbon number of 1 to 20, a cyano group, a nitro group, a heterocyclic group, a halogen atom, a carboxyl group, an acyl group having a carbon number of 2 to 20, a hydroxyl group and an alkylsilyl group having a carbon number of 1 to 20, or a group represented by the following formula (1-2).. 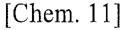 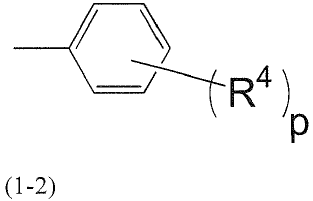 Wherein, R⁴ is independently a functional group selected from the group consisting of a hydrogen atom, an alkyl group having a carbon number of 1 to 20, a cycloalkyl group having a carbon number of 3 to 20, an aryl group having a carbon number of 6 to 20, an alkoxy group having a carbon number of 1 to 20, a cyano group, a nitro group, a heterocyclic group, a halogen atom, a carboxyl group, a hydroxyl group, a cycloalkyl group having a alkyl group having a carbon number of 3 to 20, and an alkylsilyl group having a carbon number of 1 to 20, R5 is a hydrogen atom or an alkyl group having a carbon number of 1 to 10, m is an integer of 1 to 4, and p is an integer of 0 to 5. R⁴ may be the same or different when p is an integer of 2 or more.

In the invention, at least one R' of two or more cyclic compounds represented by the formula (1-1) is the group represented by the formula (1-2), and the content of the group is 10 mol% to 90 mol% of R'. It is preferably 35 mol% to 80 mol% and particularly preferably 50 mol% to 75mol%.

As the cyclic compound represented by the formula (1-1), preferably compounds represented by the following formula (2) are mentioned. 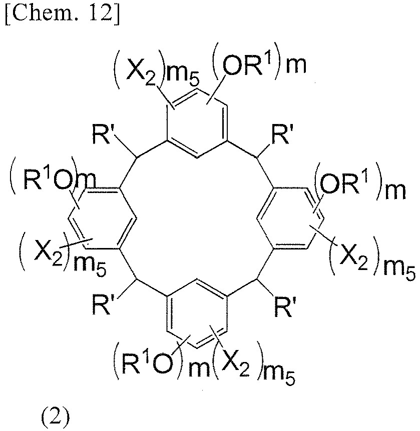 (In the formula (2), R¹, R' and m are the same as described above. X₂ is a hydrogen atom or a halogen atom, m₅ is an integer of 0 to 3, and m + m₅ = 4.)

As the cyclic compound represented by the formula (1-1), more preferably compounds represented by the following formula (3) are mentioned. 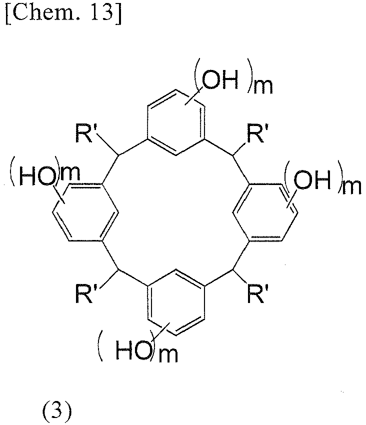 (In the formula (3), R' and m are the same as described above.)

As the cyclic compound represented by the formula (1-1), still more preferably the following compounds are mentioned.
In such compounds, it is preferable that R' comprises a group selected from the group consisting of groups represented by the following formulae (1-3). With the proviso that all R' are not entirely the same kind of groups.

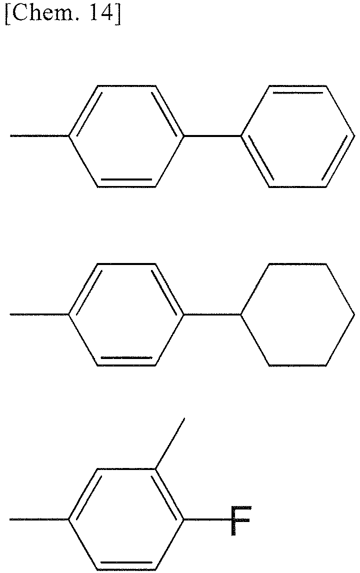

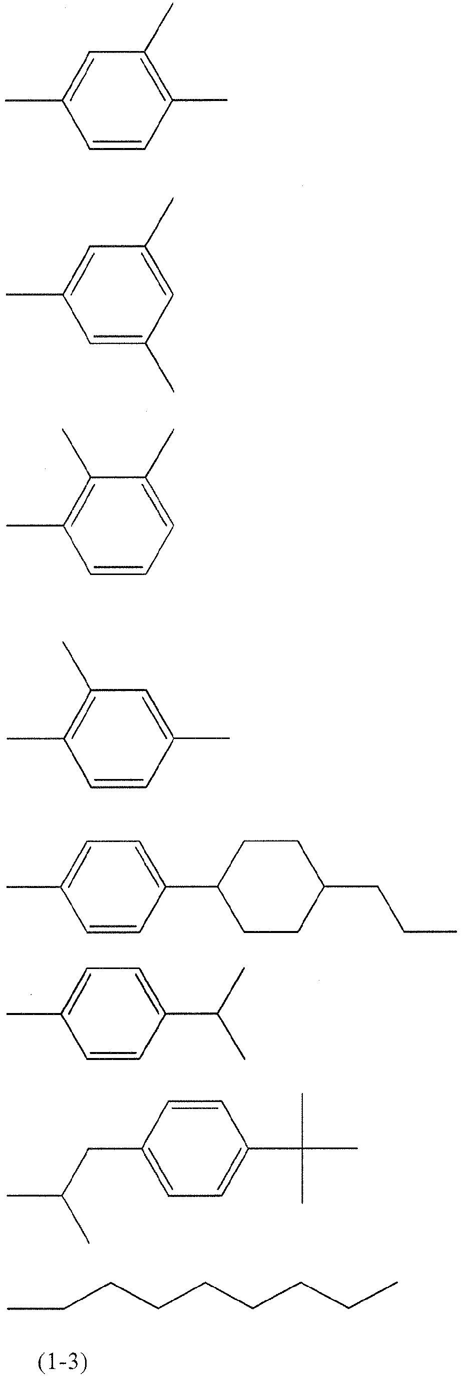

The cyclic compound represented by the formula (1-1) has a glass transition temperature of 200°C or more, is high in the heat resistance, excels in the film-forming properties because of the amorphous nature, and does not have sublimability. Further, surprisingly, the cyclic compound has features that the extinction coefficient for a light of 193 nm is relatively low and the reflective index is high even though having benzene structure.

Also, the cyclic compound is extremely excellent in practicality because in the productive aspect it can be produced in a high yield by dehydration condensation reacting two or more of various aldehydes including industrially produced aromatic aldehydes with phenols such as resorcinol, pyrogallol and the like, which both are as materials, with non-methalic catalyst such as hydrochloric acid and the like.

Further, the cyclic compound can suppress intermixing as a muli-layer resist is fomed, because it is hardly-soluble in propylene glycol monomethyl ether acetate (PGMEA) generally used as a resist solvent and soluble in propylene glycol monomethyl ether (PGME) and cyclohexanone.

The molecular weight of the cyclic compound represented by the formula (1-1) is 700 to 5000, preferably 800 to 2000, and more preferably 1000 and 2000. Within the above range, the resolution is improved while maintaining the film-forming properties required for the resist.

The cyclic compounds in the invention may take a cis-isomer or a trans-isomer as each compound, but may be either one or a mixture of them.

The cyclic compound represented by the formula (1-1) is obtained by condensation reacting two or more selected from the group consisting of aldehydes (A1) represented by the formula (4-1) (with the proviso that at least one is an aldehyde represented by the following formula (4-2)) with one or more selected from the group consisting of phenolic compounds (A2).

The aldehyde used in the invention is represented by the following formula (4-1): 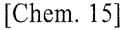 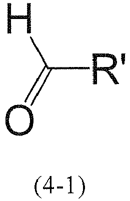 (in the formula (4-1), R' is the same as described above).
It includes, for example, formaldehyde, acetoaldehyde, propanal, butanal, pentanal, hexanal, octanal, 1-nonanal, 3-(4-t-butylphenyl)-2-isobutylaldehyde, 4-fluoro-3-methylbenzaldehyde, benzaldehyde, methylbenzaldehyde, dimethylbenzaldehyde, ethylbenzaldehyde, butylbenzaldehyde, ethylmethylbenzaldehyde, diethylbenzaldehyde, anisaldehyde, naphtoaldehyde, anthraldehyde, cyclopropylbenzaldehyde, cyclobutylbenzaldehyde, cyclopentylbenzaldehyde, biphenylaldehyde, naphthylbenzaldehyde, adamantylbenzaldehyde, norbornylbenzaldehyde, lactylbenzaldehyde, isopropylbenzaldehyde, normalpropylbenzaldehyde, bromobenzaldehyde, dimethylaminobenzaldehyde, hydroxybenzaldehyde, dihydroxybenzaldehyde, trihydroxybenzaldehyde and the like. 1-nonanal, 3-(4-t-butylphenyl)-2-isobutylaldehyde, dimethylbenzaldehyde, biphenylaldehyde and 4-fluoro-3-methylbenzaldehyde are preferable, and dimethylbenzaldehyde, biphenylaldehyde and 4-fluoro-3-methylbenzaldehyde are more preferable.

At least one of the aldehydes (A1) used in the invention is an aldehyde represented by the following formula (4-2). Preferably, two or more of the aldehydes (A1) are aldehydes represented by the following formula (4-2). 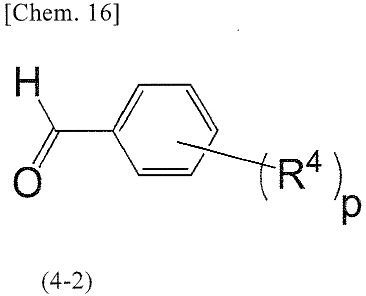 As the aldehyde represented by the formula (4-2) are menthined, for example, benzaldehyde, methylbenzaldehyde, dimethylbenzaldehyde, ethylbenzaldehyde, propylbenzaldehyde, butylbenzaldehyde, pentylbenzaldehyde, hexylbenzaldehyde, cyclopropylbenzaldehyde, cyclobutylbenzaldehyde, cyclopentylbenzaldehyde, cyclohexylbenzaldehyde, cycloheptylbenzaldehyde, cyclooctylbenzaldehyde, cyclononylbenzaldehyde, cyclohexylmethylbenzaldehyde, cyclohexylethylbenzaldehyde, methylcyclohexylbenzaldehyde, ethylcyclohexylbenzaldehyde, propylcyclohexylbenzaldehyde, butyleyclohexylbenzaldehyde, benzaldehyde fluoride, methylbenzaldehyde fluoride, ethylbenzaldehyde fluoride, dimethylbenzaldehyde fluoride, propylbenzaldehyde fluoride, biphenylaldehyde, hydroxylbenzaldehyde, nitrobenzaldehyde, methylsilylbenzaldehyde, ethylsilylbenzaldehyde, propylsilylbenzaldehyde, cyanobenzaldehyde, methoxybenzaldehyde, ethoxybenzaldehyde, methoxymethylbenzaldehyde, ethoxymethylbenzaldehyde, methoxyethylbenzaldehyde, ethoxyethylbenzaldehyde, methoxypropylbenzaldehyde, ethoxypropylbenzaldehyde, benzaldehyde bromide, carboxylbenzaldehyde, naphthylbenzaldehyde, anthracenylbenzaldehyde, phenanthrenylbenzaldehyde and the like. Benzaldehyde, methylbenzaldehyde, dimethylbenzaldehyde, ethylbenzaldehyde, propylbenzaldehyde, cyclohexylbenzaldehyde, cyclohexylmethylbenzaldehyde, methylcyclohexylbenzaldehyde, ethylcyclohexylbenzaldehyde, propylcyclohexylbenzaldehyde, butylcyclohexylbenzaldehyde, methylbenzaldehyde fluoride, ethylbenzaldehyde fluoride, dimethylbenzaldehyde fluoride, propylbenzaldehyde fluoride and biphenylaldehyde are preferable. Methylbenzaldehyde, dimethylbenzaldehyde, ethylbenzaldehyde, propylbenzaldehyde, cyclohexylbenzaldehyde, methylbenzaldehyde fluoride and biphenylaldehyde are more preferable.

The aldehyde represented by the formula (4-2) may have a linear or branched alkyl group having a carbon number of 1 to 4, a cyano group, a hydroxyl group, a halogen atom and the like within a range not damaging the effect of the invention. The aldehyde represented by the formula (4-2) may be used in a combination of two or more.

As an example of the phenolic compound (A2), phenol, catechol, resorcinol, hydroquinone, pyrogallol and the like are mentioned. Resorcinol and pyrogallol are preferable, and resorcinol is more preferable. The phonolic compound (A2) may have a linear or branched alkyl group having a carbon number 1 to 4, a cyano group, a hydroxyl group, a halogen atom and the like within a range not damaging the effect of the invention. The phonolic compound (A2) may be used alone or in a combination of two or more.

The cyclic compound (A) represented by the formula (1-1) can be produced by any of known methods. For example, the cyclic compound (A) is obtained by reacting 1 mol of the mixture of the aldehydes (A1) with 0.1 to 10 mol of the phenolic compound (A2) with an acid catalyst (hydrochloric acid, sulfuric acid, p-toluenesulfonic acid or the like) in an organic solvent such as methanol, ethanol or the like at 60 to 150 °C for approximate 0.5 to 20 hours, filtrating, washing with alcohols such as methanol and the like, washing with water, separating through filtration and drying the resulting product. Alternatively, the cyclic compound (A) is also obtained by similarly reacting them using a basic catalyst (sodium hydroxide, barium hydroxide, 1,8-diazabicyclo[5.4.0]undecene-7 or the like) instead of the acid catalyst. Furthermore, the cyclic compound (A) can be also produced by making the above aldehyde (A1) into a dihalogen compound with halogenated hydrogen or halogen gas and reacting isorated dihalogen compound with the phenolic compound (A2).

In addition, it is desirable that the cyclic compound (A) represented by the formula (1-1) is produced by preparing a mixed solution (A) consisting of the phenolic compound (A2), an acid catalyst and an alchol, preparing a mixed solution (B) consisting of two or more selected from the group consisting of the aldehydes (A1), and adding the mixed solution (B) dropwise to the mixed solution (A). If the aldehyde (A1) is added dropwise without the mixing, the desired composition can not be obtained.

It is preferable to use two or more of the aldehydes (A1) and two or more of the phenolic compounds (A2). It is more preferable to use two or more of the aldehydes (A1) represented by the formula (4-2) and two or more of the phenolic compounds (A2). By using two or more of the aldehydes (A1) represented by the formula (4-2) and two or more of the phenolic compounds (A2) is improved the solubility of the resulting cyclic compound (A) in semiconductor safety solvents.

The cyclic compound (A) used in the invention may be purified to reduce the amount of residual metal, if necessary. If the acid catalyst and cocatalyst remain, the storage stability of the radiation sensitive composition is generally lowered, or if the basic catalyst remains, the sensitivity of the radiation sensitive composition is generally lowered, so that the purification may be conducted for the purpose of reducing the remaining amount of the catalyst.

The purification may be carried out by any of known methods without limitation as long as the cyclic compound (A) is not modified, which includes, for example, a method of washing with water, a method of washing with an acidic aqueous solution, a method of washing with a basic aqueous solution, a method of treating with an ion exchange resin, a method of treating with a silica gel column chromatography and so on. The purification is more preferably conducted in a combination of two or more of the above methods.

The acidic aqueous solution, basic aqueous solution, ion exchange resin and silica gel column may be properly selected depending upon the amount and kind of the metal, acidic compound and basic compound to be removed and the kind of the cyclic compound (A) to be purified. For example, as the acidic aqueous solution is mentioned an aqueous solution of hydrochloric acid, nitric acid or acetic acid having a concentration of 0.01 to 10 mol/L, and as the basic aqueous solution is mentioned an aqueous solution of ammonia having a concentration of 0.01 to 10 mol/L, and as the ion exchange resin is mentioned a cation exchange resin such as Amberlyst 15J-HG Dry manufactured by Organo Corporation.

The drying may be conducted after the purification. The drying can be carried out by a known method such as, but not limited to, a vacuum drying and a hot-air drying under the conditions not changing the cyclic compound (A).

The cyclic compound (A) represented by the formula (1-1) can be used as a material to form an amorphous film with spin coating. Also, it is applicable to a general semiconductor production process.

The invention can include the acid crosslinking agent (G) and the acid generator (C) to suppress intermixing.

Listing specifical examples of the acid crosslinking agen (G) useable in the invention, it can include melamine compounds, guanamine compounds, glycoluril compounds or urea compounds which are substituted with at least one group selected from methylol group, alkoxymethyl group and acyloxy group, and epoxy compounds, thioepoxy compounds, isocyanate compounds, azide compounds, compounds containing a double bond such as alkenyl ether group and the like. These may be used as an additive, but these crosslinking groups may be introduced into side chains of a polymer as a pendant group. Also, a compound containing a hydroxyl group is used as the acid crosslinking agent (G).

Exemplifying the epoxy compound among the compounds listed as the acid crosslinking agent (G), tris(2,3-epoxypropyl)isocyanurate, trimethylolmethane triglycidylether, trimethylolpropane triglycidylether, triethylolethane triglycidylether and the like are exemplified. Specifically exemplifying the melamine compound, it includes hexamethylol melamine, hexamethoxymethyl melamine, a compound that 1 to 6 methylol groups of hexamethylol melamine are methoxymethylated or a mixture thereof, hexamethoxyethyl melamine, hexasiloxymethyl melamine, and a compound that 1 to 6 methylol groups of hexamethylolmelamine are acyloxymethylated or a mixture thereof. As the guanamine compound are mentioned tetramethylolguanamine, tetramethoxymethylguanamine, a compound that 1 to 4 methylol groups of tetramethylolguanamine are methoxymethylated or a mixture thereof, tetramethoxyethylguanamine, tetraacyloxyguanamine, and a compound that 1 to 4 methylol groups of tetramethylolguanamine are acyloxymethylated or a mixture thereof. As the glycoluril compound are mentioned tetramethylolglycoluril, tetramethoxyglylcoluril, tetramethoxymethylglycoluril, a compound that 1 to 4 methylol groups of tetramethylolglycoluril are methoxymethylated or a mixture thereof, and a compound that 1 to 4 methylol groups of tetramethylolglycoluril are acyloxymethylated or a mixture thereof. As the urea compound, tetramethylolurea, tetramethoxymethylurea, a compound that 1 to 4 methylol groups of tetramethylolurea are methoxymethylated or a mixture thereof, tetramethoxyethylurea and the like are mentioned.

As the compound containing alkenyl ether group are mentioned ethylene glycol divinyl ether, triethylene glycol divinyl ether, 1,2-propanediol divinyl ether, 1,4-butanediol divinyl ether, tetramethylene glycol divinyl ether, neopenthyl glycol divinyl ether, trimethylol propane trivinyl ether, hexanediol divinyl ether, 1,4-cyclohexanediol divinyl ether, pentaerythritol trivinyl ether, pentaerythritol tetravinyl ether, sorbitol tetravinyl ether, sorbitol pentavinyl ether, trimethylol propane trivinyl ether and the like.

The blending amount of the acid-diffusion controller (E) is preferably 5 to 50 parts by mass and particularly preferably 10 to 40 parts by mass for 100 parts by mass of the cyclic compound (A). If the amount is less than 5 parts by mass, it may cause mixing with the resist, and if the amount is more than 50 parts by mass, the anti-reflection effect may be decreased or the crosslinked film may be cracked.

In the invention, the acid generator (C) to further accelerate the crosslinking reaction by heat can be added. There are the acid generators (C) that generates an acid by thermal decomposition and that generates an acid by light irradiation, and any of these is capable of being added.

As the acid generator (C) used in the invention are mentioned the followings:
1) onium salt of the following general formula (P1a-1), (p1a-2), (P1a-3) or (p1b),
2) diazomethane derivative of the following general formula (P2),
3) glyoxime derivative of the following general formula (P3),
4) bissulfonate derivative of the following general formula (P4),
5) sulfonic acid ester of N-hydroxyimide compound of the following general formula (P5),
6) β-ketosulfonic acid derivative,
7) disulfone derivative,
8) nitrobenzylsulfonate,
9) sulfonic acid ester derivative,
and the like. 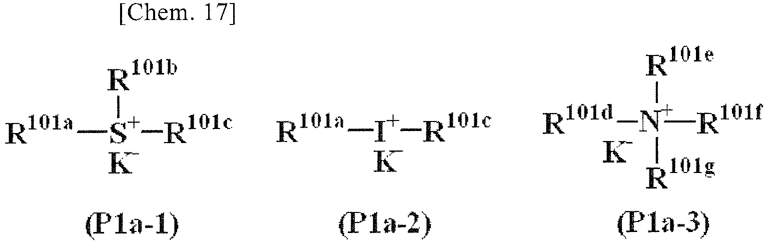 (Wherein, R^{101a}, R^{101b} and R^{101c} each represent an linear, branched or cyclic alkyl, alkenyl, oxoalkyl or oxoalkenyl group having a carbon number of 1 to 12, an aryl group having a carbon numer of 6 to 20, or an aralkyl or aryloxoalkyl group having a carbon number of 7 to 12, and a part or all of hydrogen atoms in these group may be substituted by an alkoxy group or the like. Also, R^{101b} and R^{101c} may form a ring, and if they form a ring, R^{101b} and R^{101c} each represent an alkylen group having a carbon number of 1 to 6. K- represents a non-nucleophillic counter ion. R^{101d}, R^{101e}, R^{101f} and R^{101g} are represented by adding a hydrogen atom to R^{101a}, R^{101b} and R^{101c}. R^{101d} and R^{101e}, and R^{101d}, R^{101e} and R^{101f} may form a ring, and if they form a ring, R^{101d} and R^{101e}, and R^{101d} , R^{101e} and R^{101f} represent an alkylene group having a carbon number 3 to 10. Alternatively, they represent a heteroaromatic ring having a nitrogen atom of the formula in its ring.)

R^{101a}, R^{101b}, R^{101c}, R^{101d}, R^{101e}, R^{101f} and R^{101g} may be the same or different each other, and specifically as the alkyl group are mentioned methyl group, ethyl group, propyl group, isopropyl group, n-butyl group, sec-butyl group, tert-butyl group, pentyl group, hexyl group, heptyl group, octyl group, cyclopentyl group, cyclohexyl group, cycloheptyl group, cyclopropylmethyl group, 4-methylcyclohexyl group, cyclohexylmethyl group, norbornyl group, adamantly group and the like. As the alkenyl group, vinyl group, allyl group, propenyl group, butenyl group, hexenyl group, cyclohexenyl group and the like are mentioned. As the oxoalkyl group, 2-oxocyclopentyl group, 2-oxocyclohexyl group and the like are mentioned, and 2-oxopropyl group, 2-cyclopentyl-2-oxoethyl group, 2-cyclohexyl-2-oxoethyl group, 2-(4-methylcyclohexyl)-2-oxoethyl group and the like can be mentioned. As the aryl group are mentioned phenyl group, naphthyl group and the like, alkoxyphenyl groups such as p-methoxyphenyl group, m-methoxyphenyl group, o-methoxyphenyl group, ethoxyphenyl group, p-tert-butoxyphenyl group, m-tert-butoxyphenyl group and the like, alkyl phenyl groups such as 2-methylphenyl group, 3-methylphenyl group, 4-methylphenyl group, ethylphenyl group, 4-tert-butylphenyl group, 4-butylphenyl group, dimethylphenyl group and the like, alkylnaphthyl groups such as methylnaphthyl group, ethylnaphthyl group and the like, alkoxynaphthyl groups such as methoxynaphthyl group, ethoxynaphthyl group and the like, dialkylnaphthyl groups such as dimethylnaphthyl group, diethylnaphthyl group and the like, dialkoxynaphthyl groups such as dimethoxynaphthyl group, diethoxynaphthyl group and the like. As the aralkyl group, benzyl group, phenylethyl group, phenethyl group and the like are mentioned. As the aryloxoalkyl group, 2-aryl-2-oxoethyl groups such as 2-phenyl-2-oxoethyl group, 2-(1-naphthyl)-2-oxoethyl group, 2-(2-naphthyl)-2-oxoethyl group and the like are mentioned. As the non-nucleophillic counter ion of K- are mentioned halide ions such as chloride ion, bromide ion and the like, fluoroalkylsulfonates such as triflate, 1,1,1-trifluoroethansulfonate, nonafluorobutanesulfonate and the like, arylsulfonates such as tosylate, benzenesulfonate, 4-fluorobenzenesulfonate, 1,2,3,4,5-pentafluorobenzenesulfonate and the like, alkylsulfonates such as mesylate, butanesulfonate and the like.

Also, R^{101d} is, the heteroaromatic ring that R^{101e}, R^{101f} and R^{101g} have a nitrogen atom of the formula in its ring are exemplified by imidazole derivatives (for example, imidazole, 4-methylimidazole, 4-methyl-2-phenylimidazole and the like), pyrazole derivatives, furazan derivatives, pyrroline derivatives (for example, pyrroline, 2-methyl-1-pyrroline and the like), pyrrolidine derivatives (for example, pyrrolidine, N-methylpyrrolidine, pyrrolidinone, N-methylpyrrolidone and the like), imidazoline derivatives, imidazolidine derivatives, pyridine derivatives (for example, pyridine, methylpyridine, ethylpyridine, propylprydine, butylprydine, 4-(1-butylpentyl)pyridine, dimethylprydine, trimethylprydine, triethylprydine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, dimethylaminopyridine and the like), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline, 3-quinolinecarbonitrile and the like), isoquinoline derivatives, cinnoline derivatives, quinazoline derivatives, quinoxalline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, uridine derivatives and so on.

The general formula (p1a-1) and the general formula (p1a-2) have both effects as a photoacid generator (C) and a thermal acid generator (C), while the general formula (p1a-3) acts as a thermal acid generator (C). 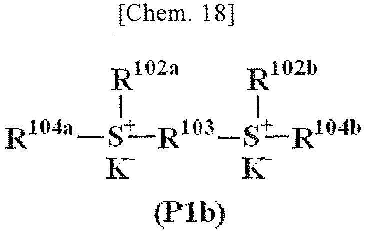 (Wherein, R^{102a} and R^{102b} each represent a linear, branched or cyclic alkyl group having a carbon number of 1 to 8. R¹⁰³ represents a linear, branched or cyclic alkylene group having a carbon number of 1 to 10. R^{104a} and R^{104b} each represent 2-oxoalkyl group having a carbon number of 3 to 7. K- represents a non-nucleophillic counter ion.)

As R^{102a} and R^{102b} are specifically mentioned methyl group, ethyl group, propyl group, isopropyl group, n-butyl group, sec-butyl group, tert-butyl group, pentyl group, hexyl group, heptyl group, octyl group, cyclopentyl group, cyclohexyl group, cyclopropylmethyl group, 4-methylcyclohexyl group, cyclohexylmethyl group and the like. As R¹⁰³ are mentioned methylene group, ethylene group, propylene group, butylene group, pentylene group, hexylene group, heptylene group, octylene group, nonylene group, 1,4-cyclohexylene group, 1,2-cyclohexylene group, 1,3-cyclopentylene group, 1,4-cyclooctylene group, 1,4-cyclohexanedimethylene group and the like. As R^{104a} and R^{104b}, 2-oxopropyl group, 2-oxocyclopentyl group, 2-oxoxcyclohexyl group, 2-oxocycloheptyl group and the like. K⁻ can include the same as explained for the formulae (P1a-1), (P1a-2) and (P1a-3). 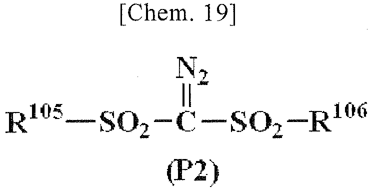 (Wherein, R¹⁰⁵ and R¹⁰⁶ represent a linear, branched or cyclic alkyl or halogenated alkyl group having a carbon number of 1 to 12, an aryl or halogenated aryl group having a carbon number of 6 to 20, or an aralkyl group having a carbon number of 7 to 12.)

As the alkyl group of R¹⁰⁵ and R¹⁰⁶ are menthioned methyl group, ethyl group, propyl group, isopropyl group, n-butyl group, sec-butyl group, tert-butyl group, pentyl group, hexyl group, heptyl group, octyl group, amyl group, cyclopentyl group, cyclohexyl group, cycloheptyl group, norbornyl group, adamantly group and the like. As the halogenated alkyl group, trifluoromethyl group, 1,1,1-trifluoroethyl group, 1,1,1-trichloroethyl group, nonafluorobutyl group and the like are mentioned. As the aryl group are mentioned phenyl group, alkoxyphenyl groups such as p-methoxyphenyl group, m-methoxyphenyl group, o-methoxyphenyl group, ethoxyphenyl group, p-tert-butoxyphenyl group, m-tert-butoxyphenyl group and the like, alkylphenyls group such as 2-methylphenyl group, 3-methylphenyl group, 4-methylphenyl group, ethylphenyl group, 4-tert-butylphenyl group, 4-butylphenyl group, dimethylphenyl group and the like. As the halogenated aryl group, fluorophenyl group, chlorophenyl group, 1,2,3,4,5-pentafluorophenyl group and the like are mentioned. As the aralkyl group, benzyl group, phenethyl group and the like are mentioned. 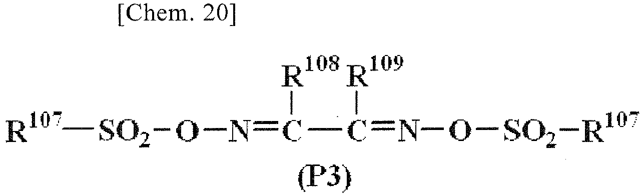 (Wherein, R¹⁰⁷, R¹⁰⁸ and R¹⁰⁹ represent a linear, branched or cyclic alkyl or halogenated alkyl group having a carbon number of 1 to 12, an aryl or halogenated aryl group having a carbon number of 6 to 20, or an aralkyl group having a carbon number of 7 to 12. R¹⁰⁸ and R¹⁰⁹ may bind each other to form a cyclic structure, if they form the cyclic structure, R¹⁰⁸ and R¹⁰⁹ each represent a linear or branced alkylen group having a carbon number of 1 to 6.)

As the alkyl, halogenated alkyl, aryl, halogenated aryl and aralkyl groups of R¹⁰⁷, R¹⁰⁸ and R¹⁰⁹, the same groups as explained for R¹⁰⁵ and R¹⁰⁶ are mentioned. In addition, as the alkylene group of R¹⁰⁸ and R¹⁰⁹, methylen group, ethylene group, propylene group, butylene group, hexylene group and the like are mentioned. 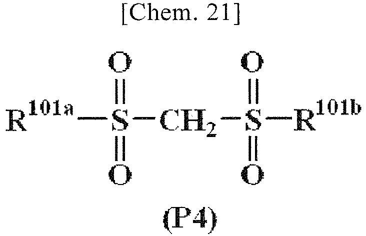 (Wherein, R^{101a} and R^{101b} are the same as described above.) 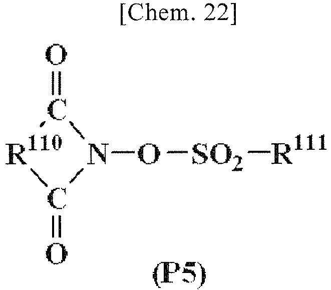 (Wherein, R¹¹⁰ represents an arylene group having a carbon number of 6 to 10, an alkylene group having a carbon number of 1 to 6, or an alkenylene group having a carbon number of 2 to 6, and a part or all of hydrogen atoms of theses groups may be further substituted by a linear or branched alkyl or alkoxy group having a carbon number of 1 to 6, a nitro group, an acetyl group or a phenyl group. R¹¹¹ represents a linear, branced or substituted alkyl, alkenyl or alkoxyalkyl group having a carbon number of 1 to 8, a phenyl group, or a naphthyl group, a part or all of hydrogen atoms of these groups may be further substituted by an alkyl or alkoxy group having a carbon number of 1 to 4; a phenyl group which may be substituted by an alkyl group having a carbon number of 1 to 4, alkoxy group, nitro group or acetyl group; a heteroaromatic group having a carbon number of 3 to 5; or a chlorine atom, or fluorine atom.)

Herein, as the arylene group of R¹¹⁰, 1,2-phenylene group, 1,8-naphthylene group and the like are mentioned, as the alkylene group of R¹¹⁰, methylene group, ethylene group, trimethylene group, tetramethylene group, phenylethylene group, norbornane-2,3-diyl group and the like are mentioned, and as the alkenylene group of R¹¹⁰, 1,2-vinylene group, 1-phenyl-1,2-vinylene group, 5-norbornene-2,3-diyl and the like are mentioned. As the alkyl group of R¹¹¹ are mentioned the same as those of R^{101a}-R^{101c}, as the alkenyl group of R¹¹¹ are mentioned vinyl group, 1-propenyl group, allyl group, 1-butenyl group, 3-butenyl group, isoprenyl group, 1-pentenyl group, 3-pentenyl group, 4-pentenyl group, dimethyl allyl group, 1-hexenyl group, 3-hexenyl group, 5-hexenyl group, 1-heptenyl group, 3-heptenyl group, 6-heptenyl group, 7-octenyl group and the like, and as the alkoxyalkyl group of R¹¹¹ are mentioned methoxymethyl group, ethoxymethyl group, propoxymethyl group, butoxymethyl group, pentyloxymethyl group, hexyloxymethyl group, heptyloxymethyl group, methoxyethyl group, ethoxyethyl group, propoxyethyl group, butoxyethyl group, pentyloxyethyl group, hexyloxyethyl group, methoxypropyl group, ethoxypropyl group, propoxypropyl group, butoxypropyl group, methoxybutyl group, ethoxybutyl group, propoxybutyl group, methoxypentyl group, ethoxypentyl group, methoxyhexyl group, methoxyheptyl group and the like.

In addition, as the alkyl group having a carbon number of 1 to 4 by which a part or all of the hydrogen atoms of R¹¹⁰ and R¹¹¹ may be further substituted, methyl group, ethyl group, propyl group, isopropyl group, n-butyl group, isobutyl group, tert-butyl group and the like are mentioned. As the alkoxy group having a carbon number of 1 to 4 by which a part or all of the hydrogen atoms of R¹¹⁰ and R¹¹¹ may be further substituted, methoxy group, ethoxy group, propoxy group, isopropoxy group, n-butoxy group, isobutoxy group, tert-butoxy group and the like are mentioned. As the phenyl group which may be substituted by an alkyl group having a carbon number of 1 to 4, alkoxy group, nitro group or acetyl group are mentioned phenyl group, tolyl group, p-tert-butoxyphenyl group, p-acethylphenyl group, p-nitrophenyl group and the like. As the heteroaromatic group having a carbon number of 3 to 5, pyridyl group, furyl group and the like are mentioned.

Specifically, it includes, for example, onium salts such as tetramethylammonium trifluoromethanesulfonate, tetramethylammonium nonafluorobutanesulfonate, triethylammonium nonafluorobutanesulfonate, pyridinium nonafluorobutanesulfonate, triethylammonium camphersulfonate, pyridinium camphersulfonate, tetra-n-butylammonium nonafluorobutanesulfonate, tetraphenylammonium nonafluorobutanesulfonate, tetramethylammonium p-toluenesulfonate, diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate, trinaphthylsulfonium trifluoromethanesulfonate, cyclohexylmethyl(2-oxocyclohexyl)sulfonium trifluoromethanesulfonate, (2-norbornyl)methyl(2-oxocyclohexyl)sulfonium trifluoromethanesulfonate, ethylenebis[methyl(2-oxocyclopentyl)sulfonium trifluoromethanesulfonate], 1,2'-naphthylcarbonylmethyltetrahydrothiophenium triflate and the like, diazomethane derivatives such as bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobuthylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-amylsulfonyl)diazomethane, bis(isoamylsulfonyl)diazomethane, bis(sec-amylsulfonyl)diazomethane, bis(tert-amylsulfonyl)diazomethane, 1-cyclohexylsulfonyl-1-(tert-butylsulfonyl)diazomethane, 1-cyclohexylsulfonyl-1-(tert-amylsulfonyl)diazomethane, 1-tert-amylsulfanyl-1-(tert-butylsulfonyl)diazomethane and the like, glyoxime derivatives such as bis-(p-toluenesulfonyl)-α-dimethylglyoxime, bis-(p-toluenesulfonyl)-α-diphenylglyoxime, bis-(p-toluenesulfonyl)-α-dicyclohexylglyoxime, bis-(p-toluenesulfonyl)-α-2,3-pentanedionglyoxime, bis-(p-toluenesulfonyl)-2-methyl-3,4-pentanedionglyoxime, bis-(n-butanesulfonyl)-α-dimethylglyoxime, bis-(n-butanesulfonyl)-α-diphenylglyoxime, bis-(n-butanesulfonyl)-α-dicyclohexylglyoxime, bis-(n-butanesulfonyl)-2,3-pentanedionglyoxime, bis-(n-butanesulfonyl)-2-methyl-3,4-pentanedionglyoxime, bis-(methanesulfonyl)-α-dimethylglyoxime, bis-(trifluoromethanesulfonyl)-α-dimethylglyoxime, bis-(1,1,1-trifluoroethanesulfonyl)-α-dimethylglyoxime, bis-(tert-butanesulfonyl)-α-dimethylglyoxime, bis-(perfluorooctanesulfonyl)-α-dimethylglyoxime, bis-(cyclohexanesulfonyl)-α-dimethylglyoxime, bis-(benzenesulfonyl)-α-dimethylglyoxime, bis-(p-fluorobenzenesulfonyl)-α-dimethylglyoxime, bis-(p-tert-butylbenzenesulfonyl)-α-dimethylglyoxime, bis-(xylenesulfonyl)-α-dimethylglyoxime, bis-(camphersulfonyl)-α-dimethylglyoxime and the like, bissulfone derivatives such as bisnaphthylsulfonylmethane, bistrifluoromethylsulfonylmethane, bismethylsulfonylmethane, bisethylsulfonylmethane, bispropylsulfonylmethane, bisisopropylsulfonylmethane, bis-p-toluenesulfonylmethane, bisbenzenesulfonylmethane and the like, β-ketosulfone derivatives such as 2-cyclohexylcarbonyl-2-(p-toluenesulfonyl)propane, 2-isopropylcarbonyl-2-(p-toluenesulfonyl)propane and the like, disulfone derivatives such as diphenyldisulfone derivatives, dicyclohexyldisulfone derivatives and the like, nitrobenzylsulfonate derivatives such as 2,6-dinitrobenzyl p-toluenesulfonate, 2,4-dinitrobenzyl p-toluenesulfonate and the like, sulfonic acid ester derivatives such as 1,2,3-tris(methanesulfonyloxy)benzene, 1,2,3-tris(trifluoromethanesulfonyloxy)benzene, 1,2,3-tris(p-toluenesulfonyloxy)benzene and the like; sulfonic acid ester derivatives of N-hydroxyimide compounds, such as N-hydroxysuccinimide methanesulfonic acid ester, N-hydroxysuccinimide trifluoromethanesulfonic acid ester, N-hydroxysuccinimide ethanesulfonic acid ester, N-hydroxysuccinimide 1-propanesulfonic acid ester, N-hydroxysuccinimide 2-propanesulfonic acid ester, N-hydroxysuccinimide 1-pentanesulfonic acid ester, N-hydroxysuccinimide 1-octanesulfonic acid ester, N-hydroxysuccinimide p-toluenesulfonic acid ester, N-hydroxysuccinimide p-methoxybenzenesulfonic acid ester, N-hydroxysuccinimide 2-chloroethanesulfonic acid ester, N-hydroxysuccinimide benzenesulfonic acid ester, N-hydroxysuccinimide-2,4,6-trimethylbenzenesulfonic acid ester, N-hydroxysuccinimide 1-naphthalenesulfonic acid ester, N-hydroxysuccinimide 2-naphthalenesulfonic acid ester, N-hydroxy-2-phenylsuccinimide methanesulfonic acid ester, N-hydroxymaleimide methanesulfonic acid ester, N-hydroxymaleimide ethanesulfonic acid ester, N-hydroxy-2-phenylmaleimide methanesulfonic acid ester, N-hydroxyglutarimide methanesulfonic acid ester, N-hydroxyglutarimide benzenesulfonic acid ester, N-hydroxyphthalimide methanesulfonic acid ester, N-hydroxyphthalimide benzenesulfonic acid ester, N-hydroxyphthalimide trifluoromethanesulfonic acid ester, N-hydroxyphthalimide p-toluenesulfonic acid ester, N-hydroxynaphthalimide methanesulfonic acid ester, N-hydroxynaphthalimide benzenesulfonic acid ester, N-hydroxy-5-norbornene-2,3-dicarboxyimide methanesulfonic acid ester, N-hydroxy-5-norbornene-2,3-dicarboxyimide trifluoromethanesulfonic acid ester, N-hydroxy-5-norbornene-2,3-dicarboxyimide p-toluenesulfonic acid ester and the like. Particularly, there are preferably used onium salts such as triphenylsulfonium trifluoromethanesulfonate, (p-tert-butoxyphenyl)diphenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, tris(p-tert-butoxyphenyl)sulfonium p-toluenesulfonate, trinaphthylsulfonium trifluoromethanesulfonate, cyclohexylmethyl(2-oxocyclohexyl)sulfonium trifluoromethanesulfonate, (2-norbornyl)methyl(2-oxocyclohexyl)sulfonium trifluoromethanesulfonate, 1,2'-naphthylcarbonylmethyltetrahydrothiophenium triflate and the like, diazomethane derivatives such as bis(benzenesulfonyl)diazomethane, bis(p-toluenesulfonyl)diazomethane, bis(cyclohexylsulfonyl)diazomethane, bis(n-butylsulfonyl)diazomethane, bis(isobuthylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane and the like, glyoxime derivatives such as bis-(p-toluenesulfonyl)-α-dimethylglyoxime, bis-(n-butanesulfonyl)-α-dimethylglyoxime and the like, bissulfone derivatives such as bisnaphthylsulfonylmethane and the like, sulfonic acid ester derivatives of N-hydroxyimide compounds, such as N-hydroxysuccinimide methanesulfonic acid ester, N-hydroxysuccinimide trifluoromethanesulfonic acid ester, N-hydroxysuccinimide 1-propanesulfonic acid ester, N-hydroxysuccinimide 2-propanesulfonic acid ester, N-hydroxysuccinimide 1-pentanesulfonic acid ester, N-hydroxysuccinimide p-toluenesulfonic acid ester, N-hydroxynaphthalimide methanesulfonic acid ester, N-hydroxynaphthalimide benzenesulfonic acid ester and the like.

The acid generator (C) can be used in any one thereof alone or in a combination of two or more.
The additive amount of the acid generator (C) is preferably 0.1 to 50 parts by mass and more preferably 0.5 to 40 parts by mass for 100 parts by mass of the polyphenol compounds. If the amount is less than 0.1 part by mass, the generation amount of an acid is low and the crosslinking reaction may be insufficient, and if the amount is more than 50 parts by mass, there may be caused a mixing phenomenon by an acid transferring to the upper layer resist.

Furthermore, an acid-diffusion controller (E) to improve the storage stability can be blended into the underlayer film materials according to the invention. As the acid-diffusion controller (E), for example, basic compounds are mentioned.
The basic compound serves as a quencher to an acid in order to prevent the acid generated from the acid generator (C) in minute amounts from progressing the crosslinking reaction. As such basic compound are mentioned primary, secondary and tetrtialy aliphatic amines, hybrid amines, aromatic amines, heterocyclic amines, nitrogen-containing compounds having a carboxy group, nitrogen-contaiing compounds having a sulfonyl group, nitrogen-contaiing compounds having a hydroxyl group, nitrogen-contaiing compounds having a hydroxyphenyl group, alcoholic nitrogen-contaiing compounds, amide derivatives, imide derivatives and the like.

As the primary aliphatic amines are specifically exemplified ammonia, methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, tetraethylenepentamine and the like. As the secondary aliphatic amines are specifically exemprified dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, N,N-dimethyltetraethylenepentamine and the like. As the tertialy aliphatic amines are specifically exemprified trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, N,N,N',N'-tetramethyltetraethylenepentamine and the like.

Also, as the hybrid amines, for example, dimethylethylamine, methylethylpropylamine, benzylamine, phenethylamine, benzyldimethylamine and the like are exemprified. As a specific example of the aromatic amines and heterocyclic amines are aniline derivatives (for example, aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2.4-dinitroaniline, 2,6-dinitroaniline, 3,5-dinitroaniline, N,N-dimethyltoluidine and the like), diphenyl(p-tolyl)amine, methyldiphenylamine, triphenylamine, phenylenediamine, naphthylamine, diaminonaphthalene, pyrrole derivatives (for example, pyrrole, 2H-pyrrole, 1-methylpyrrole, 2,4-dimethylpyrrole, 2,5-dimethylpyrrole, N-methylpyrrole and the like), oxazole derivatives (for example, oxazole, isooxazole and the like), thiazole derivatives (for example, thiazole, isothiazole and the like), imidazole derivatives (for example, imidazole, 4-methylimidazole, 4-methyl-2-phenylimidazole and the like), pyrazole derivatives, furazan derivatives, pyrroline derivatives (for example, pyrroline, 2-methyl-1-pyrroline and the like), pyrrolidine derivatives (for example, pyrrolidine, N-methylpyrrolidine, pyrrolidinone, N-methylpyrrolidone and the like), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine,benzylpyridine, methoxypyridine, butoxypyridine, dimethoxypyridine, 1-methyl-2-pyridone, 4-pyrrolidinopyridine, 1-methyl-4-phenylpyridine, 2-(1 -ethylpropyl)pyridine, aminopyridine, dimethylaminopyridine and the like), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline, 3-quinolinecarbonitrile and the like), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline, adenine derivatives, adenosine derivatives, guanine derivatives, guanosine derivatives, uracil derivatives, uridine derivatives and the like.

Furthermore, as the nitrogen-containing compound having a carboxy group are exemplified, for example, aminobenzoic acid, indole carboxylic acid, aminoacid derivatives (for example, nicotine acid, alanine, arginine, asparagine acid, glutamine acid, glycine, histidine, isoleucine, glycylleucine, leucine, methionine, phenylalanine, threonine, lysine, 3-aminopyrazine-2-carboxylic acid, methoxyalanine) and the like. As the nitrogen-containing compound having a sulfonyl group, 3-pyrridinesulfonic acid and pyridinium p-toluenesulfonate are exemplified. As the nitrogen-containing compound having a hydroxyl group, the nitrogen-containing compound having a hydroxyphenyl group or alcoholic nitrogen-containing compound are exemplified 2-hydroxypyridine, aminocresol, 2,4-quinolinediol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl) pyridine, 1-(2-hydroxyethyl)piperazine, 1-[2-(2-hydroxyethoxy)ethyl]piperazine, piperidine ethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyjulolidine, 3-quinuclidinol, 3-tropanol, 1-methyl-2-pyrrolidine ethanol, 1-aziridine ethanol, N-(2-hydroxyethyl)phthalimide, N-(2-hydroxyethyl)isonicotinamide and the like. As the amide derivative are mentioned, formamide, N-methylformamide, N,N-dimethylformamide, acetoamide, N-methylacetoamide, N,N-dimethylacetoamide, propioneamide, benzamide and the like. As the imide derivative, phthalimide, succinimide, maleimide and the like are exemplified.

The blending amount of the basic compound is 0.001 to 2 parts by mass, and particularly preferably, 0.01 to 1 part by mass for 100 parts by mass of the cyclic compound (A). If the blending amount is less than 0.001 part by mass, there is not the blending effect, and if the blending amount is more than 2 parts by mass, it may not to crosslink by trapping all acids generated with heat.

Another polymer can be added to the underlayer film of the invention for the purpose of controlling the absorbance. There can be also added naphtole resin, xylene resin-based naphthol modified resin, phenol modified resin based on naphthalene resin, dicyclopentadiene resin, (meth)acrylate, a resin containing a naphthalene ring such as vinylnaphthalene, polyacenaphthylene and the like, a resin containing a biphenyl ring such as phenanthrenequinone, fluorine and the like, a resin containing a heterocyclic ring having a hetero atom such as thiophene, indene and the like, or a resin not containing a aromatic ring, which are high in the tranparency at 193 nm.

Also, the glass-transition temperature can be decreased than a conventional novolak resin by introducing a substituent of a condensed aromatic or aliphatic. In this case, the glass-transition temperature can be decreased by 10 to 50 °C, though depending on a kind of a substitutent introduced or a ratio thereof.

As another method for descrasing the glass-transition temperature is mentioned a method of substituting a hydrogen atom of a hydroxyl group in hydroxystylene with a linear, branched or cyclic alkyl group, t-butyl group, t-amyl group, acid unstable group such as acetal and the like, acetyl group, pivaloyl group and so on. The substitution ratio in this case is a range of 10 to 80 mol%, preferably 15 to 70 mol% of hydroxyl groups.

An organic solvent usable in the underlayer film material according to the invention is not particularly limited except that the polyphenol, the acid generator (C), the acid crosslinking agent (G), other additives and the like soluble therein. There are mentioned, for example, ketone-based solvent such as acetone, methylethylketone, methylisobutylketone, cyclohexanone, cyclopentanone and the like, cellosolve-based solvent such as propylene glycol monomethylether, propylene glycol monomethylether acetate and the like, ester-based solvent such as ethyl lactate, methyl acetate, ethyl acetate, butyl acetate, isoamyl acetate, ethyl lactate, methyl methoxypropionate, methyl hydroxyisobutyrate and the like, alcohol-based solvent such as methanol, ethanol, isopropanol, 1-ethoxy-2-propanol and the like, aromatic hydrocarbon such as toluene, xylene and the like, and so on. Among the solvents described above, cyclohexanone, cyclopentanone, propylene glycol monomethylether, propylene glycol monomethylether acetate, ethyl lactate and methyl hydroxyisobutyrate are particularly preferable.

The blending amount of solvent is preferable 200 to 10,000 parts by mass, and particularly preferable 300 to 5,000 parts by mass for 100 parts by mass of the cyclic compound (A).

In the method of forming an underlayer film according to the invention, it is desirable to bake to volatilize the solvent and accelerate the croslinking reaction for preventing mixing with the upper layer resist after spin coating. The baking temperature at a range of 80 to 300 °C for a range of 10 to 300 seconds is preferably used. While the thickness of the underlayer film is properly selected, it is preferable to be 30 to 20,000 nm, and particularly 50 to 15,000 nm.

After the underlayer film is made, in a two-layer process, a silica-containing resist layer or a conventional monolayer resist consisting of hydrocarbon is made on the underlayer film, and in a three-layer process process, a silica-containing intermediate layeris is made on the underlayer film and a monolayer resist layer is further made on thereon. In this case, as the photoresist composition for forming the resis layer, the known one can be used.

As a silicon-containing resist composition for a two-layer process, a silicon atom-containing polymer such as polysilsesquioxane derivative, vinylsilane derivative or the like is used as a base polymer from a point of view of oxygen gas etching resistance, and furthermore, a positive-type photoresist comprising an organic solvent, the acid generator (C), and as necessary a basic compound and the like is used. As the silicon atom-containing polymer, the known polyer used in this kind of resist composition can be used.

As a silicon-containing intermediate layer, a polysilsesquioxane-based intermediate layer is preferably used. By giving the intermediate layer an effect as an antireflection coating, the reflection can be suppressed.

If a material, which contains many aromatic groups and is high in the substrate etching resistance, is used as an underlayer film for exposure to radiation at 193nm, the k value becomes high and the substrate reflection becomes high, while the substrate reflection can be made 0.5% or less by suppressing the reflection with the intermediate layer.

As the intermediate layer having the anti-reflection effect, polysilsesquioxane, which introduces a light absorption group having a phenyl group or silicon-silicon bond and is crosslinked with an acid or heat, is preferably used for exposure to radiation at 193 nm.

An intermediated layer formed with Chemical Vapour Deposition (CVD) process can be also used. SiON film is known as an intermediate layer which is formed with CVD process and high in effect as an anti-reflection coating. The formation of intermediate layer with a spin-coating process is easy and has a merit in cost than that with CVD process. The upper layer resist in a three-layer process may be either a positive-type or a negative-tipe, and the same as a monolayer resist conventionallty used can be used.

The underlayer film according to the invention can be also used as an anti-reflection coating for a conventional monolayer resist. Because the underlayer film according to the invention is excellent in the etching resistance for ground processing, it can be also excepeted a function as a hard mask for ground processing.

When a resist layer is formed with the photoresist composition, a spin coating process is preferably used as it is for forming the underlayer film. The prebaking is conducted after spin coating the resist composition, and it is preferable to conduct at a range of 80 to 180°C for a range of 10 to 300 seconds. After that, according to the usual method, exposure to radiation is conducted, post-exposure baking (PEB) and development are conducted to obtain the resist pattern. The thickness of the resist film is particularly limited, but it is preferable to be 30 to 50 nm, and particularly to be 50 to 400 nm. Also, as exposure light, high energy lines, specifically, excimer lasers at 248 nm, 193 nm or 157 nm, soft-X-ray at 3 to 20 nm, electron beams, X-ray and the like can be mentioned.

Subsequently, the obtained resist pattern is used as a mask to conduct the etching. For etching of the underlayer film in a two-layer process, etching using oxygen gas is conducted. It is also possible to add an inert gas such as He, Ar and the like, or CO, CO₂, NH₃, SO₂, N₂, NO₂ or H₂ gas in addition to oxygen gas, and etching can be conducted with only CO₂, NH₃, SO₂, N₂, NO₂ or H₂ gas without oxygen gas. Particularly, the latter gases are used for sidewall protection to prevent the undercut in the pattern sidewall. For the etching of the intermediate layer in a three-layer process, the processing of the intermediate layer is conducted with flon-based gas by using the resist pattern as a mask. Subsequently, such oxygen gas etching is conducted, and the processing of the underlayer film is conducted by usinf the intermediate pattern as a mask.

The following etching of the workpiece substrate can be conducted according to the usual method, and for example, if a substrate is SiO₂, SiN, etching mainly using a flon-based gas is conducted, if a substrate is p-Si or Al, W, etching mainly using a bromine-based gas is conducted. When substrate processing is conducted by etching with a flon-based gas, the silicon-containing resist in a two-layer process and the silicon-containing intermediate layer in a three-layer process are stripped at the same time as the substrate processing. When a substrate is etched with a chroline-based or bromine-based gas, it is necessary to separately conduct dry-etching stripping with a flon-based gas after the substrate processing for stripping of the silicon-containing resist layer or silicon-containing intermediate layer.

The underlayer film according to the invention has a feature that is excellent in the resistance to the etching of these workpiece substrate.
In addition, the workpiece substrate is formed on a substrate. As the substrate, it is not particularly limited, and that such as Si, α-Si, p-Si, SiO₂, SiN, SiON, W, TiN, Al and the like whose material is different from the workpiece film (workpiece substrate), is used. As the workpiece substrate, several Low-k films and stopper films thereof such as Si, SiO₂, SiON, SiN, p-Si, α-Si, W, W-Si, Al, Cu, Al-Si and the like are used, and they can be formed into a thickness of usually 50 to 10,000 nm, and particularly 100 to 5,000 nm.

The glass transition temperature of the cyclic compound (A) used in the invention is preferably not lower than 100°C, more preferably not lower than 120°C, still more preferably not lower than 140°C, and particularly preferably not lower than 150°C. When the glass transition temperature is within the above range, the cyclic compound has a heat resistance capable of maintaining the pattern shape in the semiconductor lithographic process and can give performances such as high resolution and the like.

The amount of crystallization heat of the cyclic compound (A) used in the invention is preferably less than 20 J/g as determined by a differential scanning calorimetry of the glass transition temperature. Also, the value of (crystallization temperature) - (glass transition temperature) is preferably not lower than 70°C, more preferably not lower than 80°C, still more preferably not lower than 100°C, and particularly preferably not lower than 130°C. When the amount of crystallization heat is less than 20 J/g or the value of (crystallization temperature) - (glass transition temperature) is within the above range, the radiation sensitive composition easily forms an amorphous film with spin coating and can maintain the film-forming properties required for the resist over a long period of time to improve the resolution.

In the invention, the amount of crystallization heat, crystallization temperature and glass transition temperature can be determined by measurement and differential scanning calorimetry using DSC/TA-50WS manufactured by Shimadzu Corporation as described below. About 10 mg of a sample is placed in a non-sealed aluminum container and heated to a temperature at or above a melting point at a temperature rising rate of 20°C/min in a nitrogen gas flow (50 ml/min). After rapid cooling, the sample is again heated to a temperature at or above the melting point at a temperature rising rate of 20°C/min in a nitrogen gas flow (30 ml/min). After further rapid cooling, the sample is again heated to 400°C at a temperature rising rate of 20°C/min in a nitrogen gas flow (30 ml/min). A temperature at a middle point of a zone developing discontinuous portion on a base line (the point at which the specific heat reduces to half) is taken as a glass transition temperature (Tg), and a temperature of a subsequently developed exothermic peak is taken as a crystallization temperature. The amount of crystallization heat is determined by measuring heat quantity from the area of the region surrounded by the exothermic peak and the base line.

The cyclic compound (A) used in the invention is preferable to have a low sublimation under atmospheric pressure at 100°C or lower, preferably at 120°C or lower, more preferably at 130°C or lower, still more preferably at 140°C or lower, and particularly preferably at 150°C or lower. The low sublimation means that the weight reduction through a thermogravimetric analysis when being kept at a predetermined temperature for 10 min is 10%, preferably 5%, more preferably 3%, still more preferably 1%, and particularly preferably not more than 0.1%. The contamination of the exposure apparatus by the outgas generated in the exposing process can be prevented by the low sublimation. In addition, the good pattern shape can be given by low LER.

The cyclic compound (A) according to the invention satisfies preferably the requirement of F < 3.0 (F is indicates (total number of atoms)/(total number of carbon atoms - total number of oxygen atoms)), and more preferably F < 2.5. By satisfying the above conditions, the resistance to dry-etching becomes excellent.

The cyclic compound (A) used in the invention is dissolved preferably in not lower than 1% by weight, more preferably in not lower than 5% by weight and still more preferably in not lower than 10% by weight at 23°C in a solvent which is selected from propylene glycol monomethyl ether acetate (PGMEA), propylene glycol monomethyl ether (PGME), cyclohexanone (CHN), cyclopentanone (CPN), 2-heptanone, anisole, butyl acetate, ethyl propionate and ethyl lactate and exhibits the highest solubility for the cyclic compound (A), particularly preferably in not lower than 20% by weight at 23°C in a solvent which is selected from PGMEA, PGME and CHN and exhibits the highest solubility for the cyclic compound (A), and particularly preferably in not lower than 20% by weight at 23°C in PGMEA. By satisfying the above conditions, the cyclic compound can be used at the semiconductor manufacturing step in the actual production.

A halogen atom may be introduced into the cyclic compound (A) used in the invention within a range not damaging the effect of the invention. The ratio of the number of halogen atoms to the total number of constituent atoms of the cyclic compound (A) is preferably 0.1 to 60%, more preferably 0.1 to 40%, still more preferably 0.1 to 20%, particularly preferably 0.1 to 10%, and most preferably 1 to 5%. When the ratio of the halogen atom is within the above range, the film-forming properties can be maintained while increasing the sensitivity to radiation. In addition, the solubility in safety solvents can be increased.

The underlayer film material according to the invention comprises the cyclic compounds (A) represented by two or more of the formula (1-1) as described above and a solvent. In addition, it is preferable that the underlayer film material according to the invention consists of 1 to 80% by weight of a solid component and 20 to 99% by weight of a solvent, furthermore, it is preferable that the cyclic compounds (A) are 50 to 99.499% by weight based on the total weight of the solid component.

The underlayer film material according to the invention has preferably 1 to 80% by weight of a solid component and 20 to 99% by wight of a solvent, more preferably 1 to 50% by weight of a solid component and 50 to 99% by weight of a solvent, still more preferably 2 to 40% by weight of a solid component and 60 to 98% by weight of a solvent, and particularly preferably 2 to 10% by weight and 90 to 98% by weight of a solvent. The amount of the cyclic compounds (A) is 50% by weight or more, preferably 65% by weight, and more preferably 81 % by weight or more.

In the underlayer film material according to the invention, the ratio of the solid component (cyclic compound (A)/acid generator (C)/acid crosslinking agent (G)/acid-diffusion controller (E)/optional component (F)) is, when expressed by weight percentage based on solid, preferably 50-99.489/0.001-49.49/0.5-49.989/0.01-49.499/0-49.489, more preferably 50-99.489/0.001-49.49/0.5-40/0.01-5/0-15, still more preferably 60-70/10-25/1-30/0.01-3/0-1, and particularly preferably 60-70/10-25/2-20/0.01-3/0. With the above blend, the performances such as sensitivity, resolution, alkali developability and the like are excellent.

The underlayer film according to the invention is usually prepared by dissolving each component in the solvent to make a homogeneous solution and then, if necessary, filtrating with, for example, a filter having a pore diameter in the order of 0.2µm.

As the abod solvent used for preparing the underlayer film material of the invention are mentioned, for example, ethylene glycol monoalkyl ether acetates such as ethylene glycol monomethyl ether acetate, ethylene glycol monoethyl ether acetate, ethylene glycol mono-n-propyl ether acetate, ethylene glycol mono-n-butyl ether acetate, and the like; ethylene glycol monoalkyl ethers such as ethylene glycol monomethyl ether, ethylene glycol monoethyl ether, and the like; propylene glycol monoalkyl ether acetates such as propylene glycol monomethyl ether acetate, propylene glycol monoethyl ether acetate, propylene glycol mono-n-propyl ether acetate, propylene glycol mono-n-butyl ether acetate, and the like; propylene glycol monoalkyl ethers such as propylene glycol monomethyl ether, propylene glycol monoethyl ether, and the like; lactic acid esters such as methyl lactate, ethyl lactate, n-propyl lactate, n-butyl lactate, n-amyl lactate, and the like; aliphatic carboxylic acid esters such as methyl acetate, ethyl acetate, n-propyl acetate, n-butyl acetate, n-amyl acetate, n-hexyl acetate, methyl propionate, ethyl propionate, and the like; other esters such as methyl 3-methoxypropionate, ethyl 3-methoxypropionate, methyl 3-ethoxypropionate, ethyl 3-ethoxypropionate, methyl 3-methoxy-2-methylpropionate, 3-methoxybutylacetate, 3-methyl-3-methoxybutylacetate, butyl 3-methoxy-3-methylpropionate, butyl 3-methoxy-3-methylbutyrate, methyl acetoacetate, methyl pyruvate, ethyl pyruvate, and the like; aromatic hydrocarbons such as toluene, xylene, and the like; ketones such as 2-heptanone, 3-heptanone, 4-heptanone, cyclopentanone, cyclohexanone, and the like; amidos such as N,N-dimethylformamide, N-methylacetoamide, N,N-dimethylacetoamide, N-methylpyrrolidone, and the like; lactones such as γ-lactone, and the like; and so on, but it is not particularly limited. Among the solvents, propylene glycol monomethyl ether acetate can be mentioned as that generally and widely used. These solvens can be used alone or in a combination of two or more.

### EXAMPLES

The embodiments of the invention will be described in more detail with reference to the examples below. However, the invention is not limited to these examples. In the following synthesis examples and examples, the structure of each cyclic compound was identified with LC-MS measurement and ¹H-NMR measurement.

### <Synthesis Examples> Synthesis of underlayer film materials

### - Synthesis Example 1 (Synthesis of CR-1A)

Into a four-necked flack (300 mL) equipped with a dropping funnel, a Dimroth condenser, a thermometer and stirring blades, which was sufficiently dried and purged with nitrogen, were charged resorcinol (12.3 g, 0.112 mol, manufactured by Kanto Chemical Co., Inc.), dehydrated ethanol (140 mL) and 17.2 mL of concentrated hydrochloric acid (35%) under nitrogen stream to prepare an ethanol solution. Then, 3,4-dimethylbenzaldehyde (7.14 g, 0.0532 mol), 4-biphenylaldehyde (9.69 g, 0.0532 mol) and 30 mL of ethanol were mixed and added dropwise from the dropping funnel over 10 minutes, and the resulting solution was heated to 80°C in a mantle heater with stirring. The solution was continuously stirred at 80°C for 5 hours. After the completion of the reaction, the solution is left to stand to reach room temperature. Target crude crystals were produced, the ethanol was distilled off by evalopation after the reaction, and 100 mL of distilled water was added to the crude crystals. The distilled water was filterd out, the crude crystals were washed with 200 ml of distilled water six times, filterd and dried under vacuum to obtain the target product (hereinafter referred to as CR-1A) (24.6 g, 92% yield).
The analytical result with LC-MS showed that the product comprises targets with molecular weights of 905, 953, 1001, 1049 and 1097. Also, chemical shift values (δ ppm, TMS reference) of ¹H-NMR in heavy dimethyl sulfoxide were 0.5-2.3 (m, 12H), 5.4-5.6 (m, 4H), 6.0-7.6 (m, 32H) and 8.3-8.8 (m, 8H).
The content of the compound having the group represented by the formula (1-2) and derived from 3,4-dimethylbenzaldehyde was 50 mol%.
The content of the compound having the group represented by the formula (1-2) and derived from 4-biphenylaldehyde was 50 mol%.

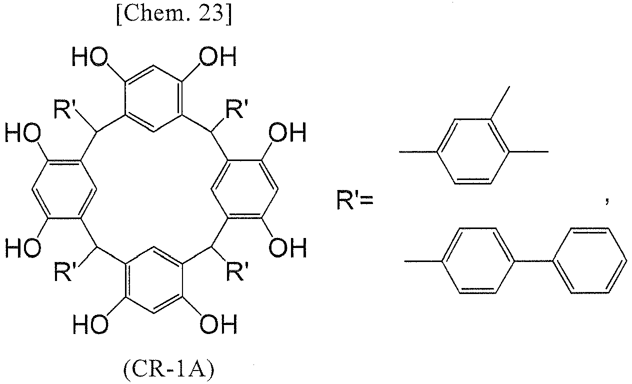

### - Synthesis Example 2 (Synthesis of CR-2A)

It was synthesized similarly to CR-1A except that 3,4-dimethylbenzaldehyde was replaced with 4-isopuropylbenzaldehyde to be one-half the amount and 4-biphenylaldehyde was replaced with 4-cyclobenzaldehyde to be three-half the amount in the synthesis example of CR-1A. As a result, CR-2A was obtained (27.9 g, 97% yield).
The analytical result with LC-MS showed that the product comprises targets with molecular weights of 961, 1001, 1041, 1081 and 1122. Also, chemical shift values (δ ppm, TMS reference) of ¹H-NMR in heavy dimethyl sulfoxide were 0.8-1.9 (m, 40H), 5.5-7.0 (m, 28H) and 8.5-9.0 (m, 8H).
According to ¹H-NMR, the content of the compound having the group represented by the formula (1-2) and derived from 4-cyclohexylbenzaldehyde was 75 mol%.
The content of the compound having the group represented by the formula (1-2) and derived from 4-isopropylaldehyde was 25 mol%.

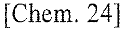

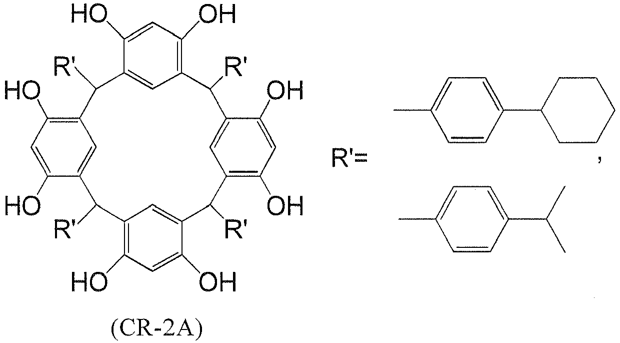

### - Synthesis Example 3 (Synthesis of CR-3A)

It was synthesized similarly to CR-1A except that 3,4-dimethylbenzaldehyde was replaced with 4-cyclohexylbenzaldehyde in the synthesis example of CR-1A. As a result, CR-3A was obtained (28.4 g, 96% yield).
The analytical result with LC-MS showed that the product comprises targets with molecular weights of 1097, 1103, 1109, 1116 and 1122. Also, chemical shift values (δ ppm, TMS reference) of ¹H-NMR in heavy dimethyl sulfoxide were 0.8-1.9 (m, 22H), 5.5-6.3 (m, 4H), 6.3-7.6 (m, 26H) and 8.3-8.7 (m, 8H).
According to ¹H-NMR, the content of the compound having the group represented by the formula (1-2) and derived from 4-cyclohexylbenzaldehyde was 50 mol%.
The content of the compound having the group represented by the formula (1-2) and derived from 4-biphenylaldehyde was 50 mol%.

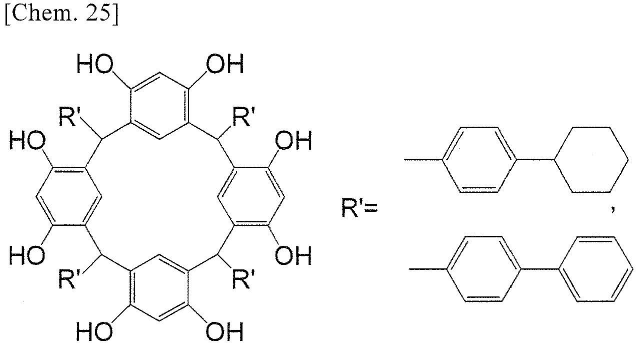

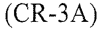

### - Synthesis Example 4 (Synthesis of CR-4A)

It was synthesized similarly to CR-2A except that 4-isopropylbenzaldehyde was replaced with 4-(propylcyclohexyl) benzaldehyde in the synthesis example of CR-2A. As a result, CR-4A was obtained (30.5 g, 99% yield).
The analytical result with LC-MS showed that the product comprises targets with molecular weights of 1122, 1164, 1206, 1248 and 1290. Also, chemical shift values (δ ppm, TMS reference) of ¹H-NMR in heavy dimethyl sulfoxide were 0.8-2.4 (m, 50H), 5.5-7.2 (m, 28H) and 8.4-9.0 (m, 8H).
According to ¹H-NMR, the content of the compound having the group represented by the formula (1-2) and derived from 4-cyclohexylbenzaldehyde was 75 mol%.
The content of the compound having the group represented by the formula (1-2) and derived from 4-(propylcyclohexyl) benzaldehyde was 25 mol%.

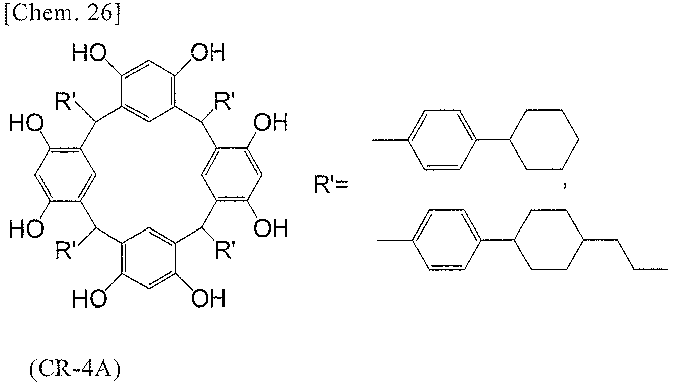

### - Synthesis Example 5 (Synthesis of CR-5A)

It was synthesized similarly to CR-2A except that 4-isopropylbenzaldehyde was replaced with 3,4-dimethylbenzaldehyde in the synthesis example of CR-2A. As a result, CR-5A was obtained (27.9 g, 98% yield).
The analytical result with LC-MS showed that the product comprises targets with molecular weights of 905, 959, 1013, 1067 and 1122. Also, chemical shift values (δ ppm, TMS reference) of ¹H-NMR in heavy dimethyl sulfoxide were 1.0-2.5 (m, 39H), 5.4-5.8 (m, 4H), 5.8-7.1 (m, 23H) and 8.2-9.0 (m, 8H).
According to ¹H-NMR, the content of the compound having the group represented by the formula (1-2) and derived from 4-cyclohexylbenzaldehyde was 75 mol%.
The content of the compound having the group represented by the formula (1-2) and derived from 3,4-dimethylbenzaldehyde was 25 mol%.

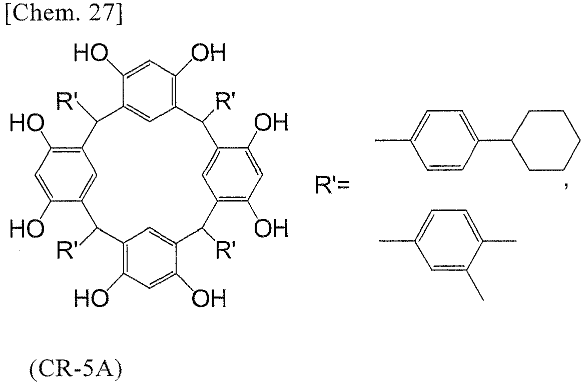

### - Synthesis Example 6 (Synthesis of CR-6A)

It was synthesized similarly to CR-2A except that 4-isopropylbenzaldehyde was replaced with 4-fluoro-3-methylbenzaldehyde in the synthesis example of CR-3A. As a result, CR-6A was obtained (27.9 g, 98% yield).
The analytical result with LC-MS showed that the product comprises targets with molecular weights of 921, 971, 1021, 1071 and 1122. Also, chemical shift values (δ ppm, TMS reference) of ¹H-NMR in heavy dimethyl sulfoxide were 1.0-2.4 (m, 36H), 5.4-5.8 (m, 4H), 6.0-8.0 (m, 23H) and 8.3-8.9 (m, 8H).
According to ¹H-NMR, the content of the compound having the group represented by the formula (1-2) and derived from 4-cyclohexylbenzaldehyde was 75 mol%.
The content of the compound having the group represented by the formula (1-2) and derived from 4-fluoro-3-methylbenzaldehyde was 25 mol%.

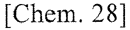

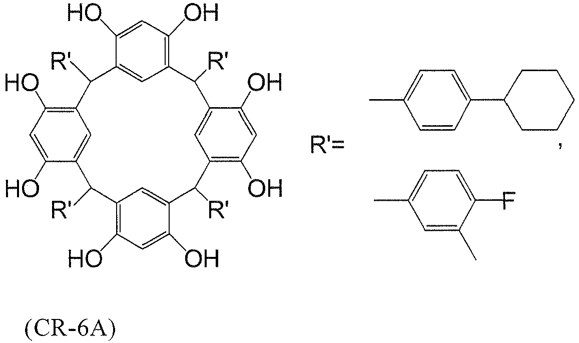

### - Synthesis Example 7 (Synthesis of CR-7A)

It was synthesized similarly to CR-2A except that 4-isopropylbenzaldehyde was replaced with n-nonanal in the synthesis example of CR-2A. As a result, CR-7A was obtained (27.0 g, 94% yield).
The analytical result with LC-MS showed that the product comprises targets with molecular weights of 937, 984, 1030, 1076 and 1122. Also, chemical shift values (δ ppm, TMS reference) of ¹H-NMR in heavy dimethyl sulfoxide were 0.5-2.7 (m, 50H), 5.5-6.0 (m, 4H), 6.0-7.3 (m, 20H) and 8.3-9.0 (m, 8H).
According to ¹H-NMR, the content of the compound having the group represented by the formula (1-2) and derived from 4-cyclohexylbenzaldehyde was 75 mol%.
The content of the compound having the group represented by the formula (1-2) and derived from n-nonanal was 25 mol%.

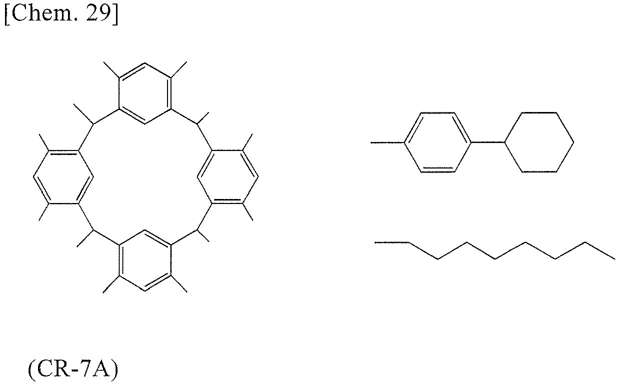

### - Synthesis Example 8 (Synthesis of CR-8A)

It was synthesized similarly to CR-2A except that 4-isopropylbenzaldehyde was replaced with 3-(4-t-butylphenyl)-2-isobutylaldehyde in the synthesis example of CR-2A. As a result, CR-8A was obtained (29.0 g, 96% yield).
The analytical result with LC-MS showed that the product comprises targets with molecular weights of 1122, 1138, 1154, 1170 and 1186. Also, chemical shift values (δ ppm, TMS reference) of ¹H-NMR in heavy dimethyl sulfoxide were 0.9-2.5 (m, 48H), 5.4-7.3 (m, 28H) and 8.3-9.0 (m, 8H).
According to ¹H-NMR, the content of the compound having the group represented by the formula (1-2) and derived from 4-cyclohexylbenzaldehyde was 75 mol%.
The content of the compound having the group represented by the formula (1-2) and derived from 3-(4-t-butylphenyl)-2-isobutylaldehyde was 25 mol%.

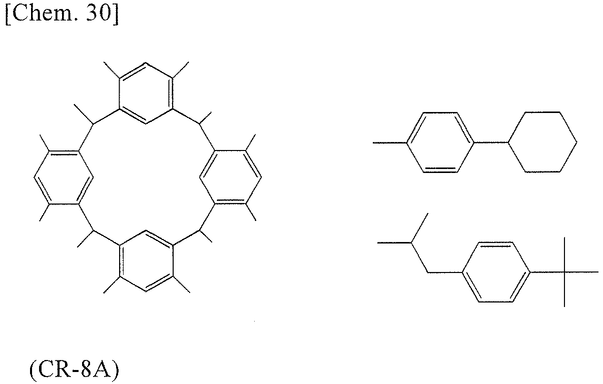

### - Synthesis Comparative Example 1 (Synthesis of CR-9A)

Into a four-necked flack (2000 mL) equipped with a dropping funnel, a Dimroth condenser, a thermometer and stirring blades, which was sufficiently dried and purged with nitrogen, were charged resorcinol (120 g, 1.09 mol, manufactured by Kanto Chemical Co., Inc.), dehydrated ethanol (1.36 L) and 168 mL of concentrated hydrochloric acid (35%) under nitrogen stream to prepare an ethanol solution. Then, 4-cyclohexylbenzaldehyde (196 g, 1.04 mol) was mixed and added dropwise from the dropping funnel over 10 minutes, and the resulting solution was heated to 80°C in a mantle heater with stirring. The solution was continuously stirred at 80°C for 5 hours. After the completion of the reaction, the solution is left to stand to reach room temperature. Target crude crystals were produced and filtered after the reaction, and 100 mL of distilled water was added thereto. The distilled water was filtered out, the crude crystals were washed with 1000 ml of distilled water six times, filtered and dried under vacuum to obtain the target product (hereinafter referred to as CR-9A) (278 g, 91% yield).
The analytical result with LC-MS showed that the compound is a target with molecular weight of 1122. Also, chemical shift values (δ ppm, TMS reference) of ¹H-NMR in heavy dimethyl sulfoxide were 0.8-1.9 (m, 44H), 5.5-5.6 (d, 4H), 6.0-6.8 (m, 24H) and 8.4-8.5 (m, 8H).
According to ¹H-NMR, the content of the compound having the group represented by the formula (1-2) and derived from 4-cyclohexylbenzaldehyde was 100 mol%.

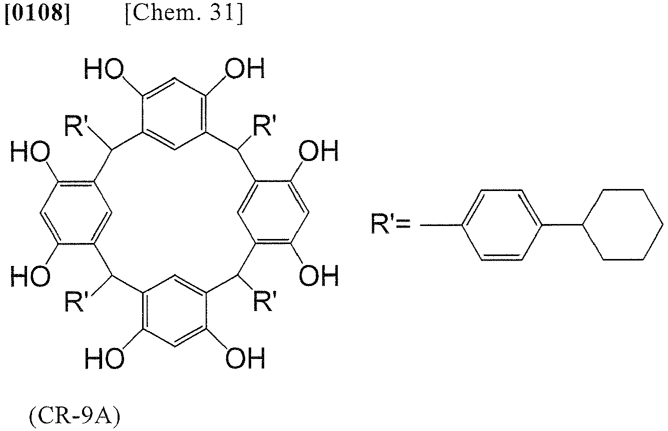

### - Synthesis Comparative Example 2 (Synthesis of CR-10A)

Into a four-necked flack (1000 mL) equipped with a dropping funnel, a Dimroth condenser, a thermometer and stirring blades, which was sufficiently dried and purged with nitrogen, were charged resorcinol (54.5 g, 0.50 mol, manufactured by Kanto Chemical Co., Inc.), dehydrated ethanol (500 mL) and 3,4-dimethylbenzaldehyde (63.1 g, 0.47 mol) under nitrogen stream to prepare an ethanol solution. Then, 40 mL of concentrated hydrochloric acid (35%) was added dropwise from the dropping funnel over 20 minutes, and the resulting solution was heated to 80°C in a mantle heater with stirring. The solution was continuously stirred at 80°C for 5 hours. After the completion of the reaction, the solution is left to stand to reach room temperature. Target crude crystals were produced and filtered after the reaction, and 100 mL of distilled water was added thereto. The distilled water was filterd out, and the crude crystals were washed with 200 mL of distilled water five times, washed with 100 mL of methanol five times, filtered and dried under vacuum to obtain the target product (hereinafter referred to as CR-10A) (theoretical yield 95.4 g, 90% yield).
The analytical result with LC-MS showed that the compound is a target with molecular weight of 905. Also, chemical shift values (δ ppm, TMS reference) of ¹H-NMR in heavy dimethyl sulfoxide were 1.8-2.2 (m, 24H), 5.6 (s, 4H), 6.0-6.8 (m, 20H) and 8.4 (s, 8H).
The content of the compound having the group represented by the formula (1-2) and derived from 3,4-dimethylbenzaldehyde was 100 mol%.

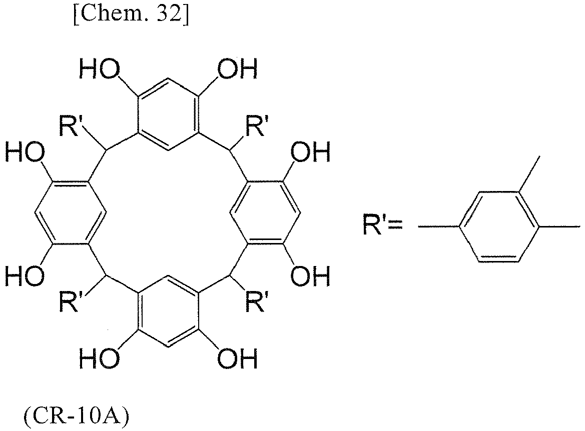

### - Synthesis Comparative Example 3 (Synthesis of CR-11A)

Into a four-necked flack (500 mL) equipped with a dropping funnel, a Dimroth condenser, a thermometer and stirring blades, which was sufficiently dried and purged with nitrogen, were charged resorcinol (11 g, 0.1 mol, manufactured by Kanto Chemical Co., Inc.), 4-fluoro-3-methylbenzaldehyde (13.8 g, 0.1 mol) and dehydrated ethanol (100 mL) under nitrogen stream to prepare an ethanol solution. The resulting solution was heated to 80°C in a mantle heater with stirring. Then, 25 mL of concentrated hydrochloric acid (35%) was added dropwise from the dropping funnel over 30 minutes, and the solution was continuously stirred at 80°C for 1.5 hours. After the completion of the reaction, the solution is left to stand to reach room temperature and thereafter cooled in an ice bath. After still standing for 1 hour, pale yellow target crude crystals were produced and filtered. The crude crystals were washed with 500 mL of methanol twice, filtered and dried under vacuum to obtain the target product (hereinafter referred to as CR-11A) (3.5 g, 15% yield).
The analytical result with LC-MS showed that the compound is a target with molecular weight of 921. Also, chemical shift values (δ ppm, TMS reference) of ¹H-NMR in heavy dimethyl sulfoxide were 2.0 (s, 12H), 5.6 (s, 4H), 6.0-6.7 (m, 20H) and 8.6 (s, 8H).
The content of the compound having the group represented by the formula (1-2) and derived from 4-fluoro-3-methylbenzaldehyde was 100 mol%.

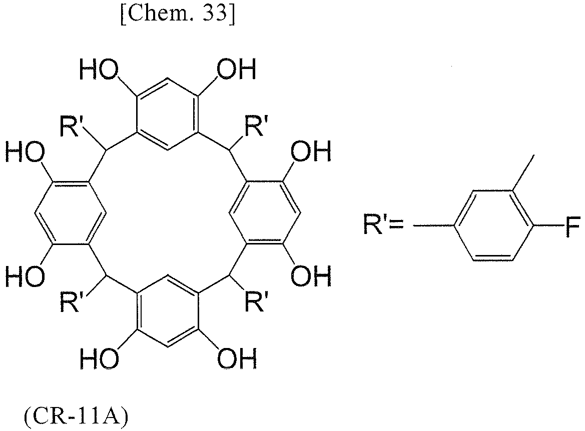

### - Synthesis Comparative Example 4 (Synthesis of CR-12A)

Into a four-necked flack (1000 mL) equipped with a dropping funnel, a Dimroth condenser, a thermometer and stirring blades, which was sufficiently dried and purged with nitrogen, were charged resorcinol (22 g, 0.2 mol, manufactured by Kanto Chemical Co., Inc.), 4-isopropylbenzaldehyde (29.6 g, 0.2 mol) and dehydrated ethanol (200 mL) under nitrogen stream to prepare an ethanol solution. The resulting solution was heated to 85°C in a mantle heater with stirring. Then, 75 mL of concentrated hydrochloric acid (35%) was added dropwise from the dropping funnel over 30 minutes, and the solution was continuously stirred at 85°C for 3 hours. After the completion of the reaction, the solution is left to stand to reach room temperature and thereafter cooled in an ice bath. After still standing for 1 hour, pale yellow target crude crystals were produced and filtered. The crude crystals were washed with 500 mL of methanol twice, filtered and dried under vacuum to obtain the target product which is a mixture of the product having the structure of trans isomer and the product having the structure of cis isomer (hereinafter referred to as CR-12A) (45.6 g, 95% yield).
The analytical result with LC-MS showed that the compound is a target with molecular weight of 960. Also, chemical shift values (δ ppm, TMS reference) of ¹H-NMR in heavy dimethyl sulfoxide were 1.1-1.3 (m, 24H), 2.6-2.7 and 2.7-2.8 (m(trans isomer) and m(cis isomer), 4H), 5.5 and 5.6 (s(trans isomer) and s(cis isomer), 4H), 6.0-6.9 (m, 24H) and 8.4-8.5 (m, 8H).
The content of the compound having the group represented by the formula (1-2) and derived from 4-isopropylbenzaldehyde was 100 mol%.

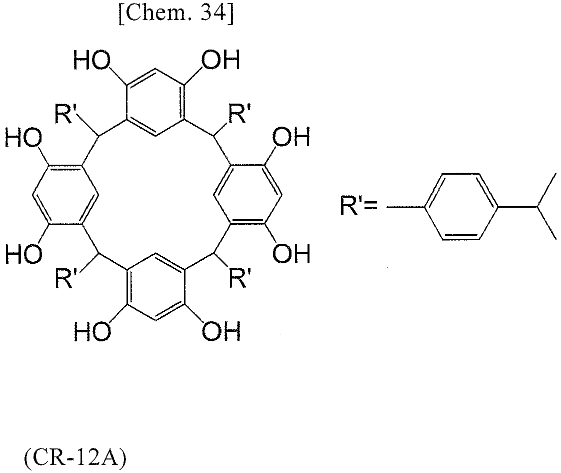

### - Synthesis Comparative Example 5 (Synthesis of CR-13A)

Into a four-necked flack (2000 mL) equipped with a dropping funnel, a Dimroth condenser, a thermometer and stirring blades, which was sufficiently dried and purged with nitrogen, were charged resorcinol (73.8 g, 0.670 mol, manufactured by Kanto Chemical Co., Inc.), dehydrated ethanol (838 mL) and 103 mL of concentrated hydrochloric acid (35%) under nitrogen stream to prepare an ethanol solution. Then, 4-(4-propylcyclohexyl)benzaldehyde (147.12 g, 0.638 mol) was mixed and added dropwise from the dropping funnel over 10 minutes, and the resulting solution was heated to 80°C in a mantle heater with stirring. The solution was continuously stirred at 80°C for 5 hours. After the completion of the reaction, the solution is left to stand to reach room temperature. After the reaction, 800 mL of distilled water was added thereto. Target crude crystals were produced and filtered, and the crude crystals were washed with 800 ml of distilled water six times, filtered and dried under vacuum to obtain the target product (hereinafter referred to as CR-13A) (202 g, 98% yield).
The analytical result with LC-MS showed that the compound is a target with molecular weight of 1290. Also, chemical shift values (δ ppm, TMS reference) of ¹H-NMR in heavy dimethyl sulfoxide were 0.8-1.9 (m, 68H), 5.5-5.7 (d, 4H), 6.0-6.8 (m, 24H) and 8.4-8.6 (m, 8H).
The content of the compound having the group represented by the formula (1-2) and derived from 4-(4-propylcyclohexyl)benzaldehyde was 100 mol%.

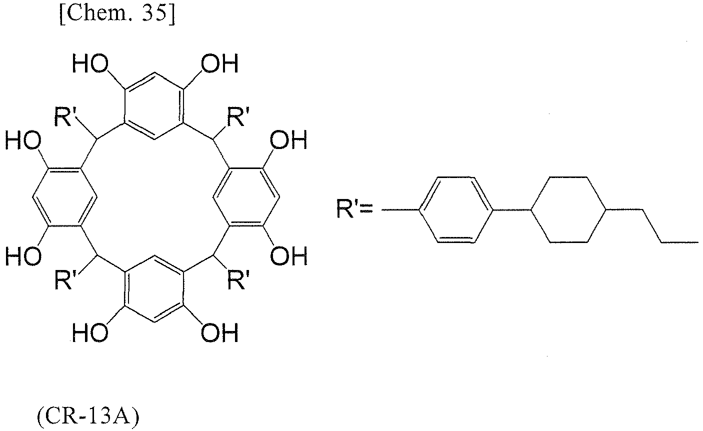

### - Synthesis Comparative Example 6 (Synthesis of CR-14A)

It was synthesized similarly to CR-12A except that 4-isopropylbenzaldehyde was replaced with biphenylaldehyde in the synthesis example of CR-12A. As a result, CR-14A was obtained (53.5 g, 98% yield).
The analytical result with LC-MS showed that the compound is a target with molecular weights of 1096. Also, chemical shift values (δ ppm, TMS reference) of ¹H-NMR in heavy dimethyl sulfoxide were 6.0-7.4 (m, 48H) and 8.6-8.7 (t, 8H).
The content of the compound having the group represented by the formula (1-2) and derived from biphenylaldehyde was 100 mol%.

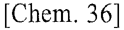

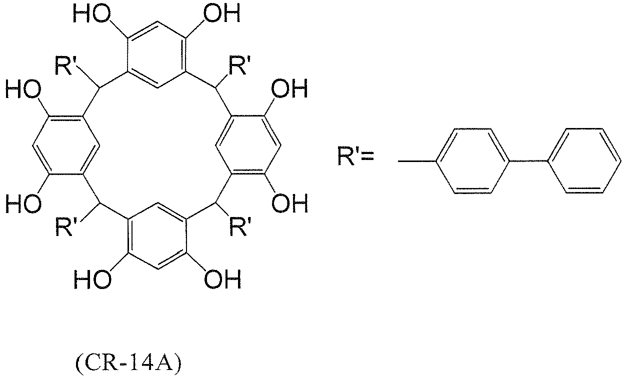

### (Examples 1 to 8 and Comparative Examples 1 to 6)

### (1) Solubility test of the compounds (mixtures) in a safety solvent

The dissolved amounts of the compounds (mixtures) obtained in Synthesis Examples 1 to 8 and Comparative Synthesis Examples 1 to 6 in propylene glycol monomethyl ether acetate (PGMEA) were evaluated. The results are shown in Table 1.
A: 5.0 wt % ≤ dissolved amount
B: 3.0 wt % ≤ dissolved amount < 5.0 wt %
C: dissolved amount < 3.0 wt %

| Table 1 | |
|---|---|
| Compound (Mixture) | Dissolve amount in PGMEA |
| obtained in Synthesis Example 1 | B |
| obtained in Synthesis Example 2 | B |
| obtained in Synthesis Example 3 | B |
| obtained in Synthesis Example 4 | A |
| obtained in Synthesis Example 5 | A |
| obtained in Synthesis Example 6 | A |
| obtained in Synthesis Example 7 | A |
| obtained in Synthesis Example 8 | A |
| obtained in Synthesis Comparative Example 1 | C |
| obtained in Synthesis Comparative Example 2 | C |
| obtained in Synthesis Comparative Example 3 | C |
| obtained in Synthesis Comparative Example 4 | C |
| obtained in Synthesis Comparative Example 5 | C |
| obtained in Synthesis Comparative Example 6 | C |

### Examples 9 to 14 and Comparative Examples 7 to 12

The compounds (mixtures) obtained in Synthesis Examples 1 to 6 and Synthesis Comparative Examples 1 to 6 were dissolved at a ratio of 5% by mass in a solvent PGME (propylene glycol monomethyl ether) or in cyclohexanone or cyclopentanone if that is not dissolved, and the resulting solution were filtered with a filter of 0.1 µm made from fluororesin to preparate each solution for forming an underlayer film.
Then, the solutions for forming an underlayer film were spin coated on silicon substrates and baked at 110°C for 90 seconds to obtain each underlayer film having a film thickness of 200 nm (hereafter referred to as Underlayer films 1 to 6, Comparative underlayer films 1 to 6).
One of two kinds of gases CF₄ gas and O₂ gas, or both of these gases was used in etching at 10 cc/min for 60 seconds, and the etching rate (nm/min) was each calculated by measuring the film thicknesses before and after the etching. The etching conditions are as shown below.

Etching apparatus: RIE-10NR manufactured by SAMCO International Inc.
Output: 50 W
Pressure: 20 Pa
Kind of gas
A: CF₄ gas flow/Ar gas flow/O₂ gas flow = 10/0/0
B: CF₄ gas flow/Ar gas flow/O₂ gas flow = 5/50/5
C: CF₄ gas flow/Ar gas flow/O₂ gas flow = 0/0/10 (cc/min)

The results are showin in Table 2.

**Table 2**

| Material | Underlayer film | Etching | | |
|---|---|---|---|---|
| | | A | B | C |
| obtained in Synthesis Example 1 | Underlayer film 1 | 15.0 | 107.4 | 59.9 |
| obtained in Synthesis Example 2 | Underlayer film 2 | 14.5 | 105.6 | 56.4 |
| obtained in Synthesis Example 3 | Underlayer film 3 | 14.2 | 90.6 | 50.1 |
| obtained in Synthesis Example 4 | Underlayer film 4 | 14.7 | 114.4 | 60.9 |
| obtained in Synthesis Example 5 | Underlayer film 5 | 14.6 | 105.9 | 59.2 |
| obtained in Synthesis Example 6 | Underlayer film 6 | 15.7 | 109.6 | 61.7 |
| obtained in Synthesis Example 7 | Comparative Underlayer film 1 | 18.9 | 131.5 | 80.0 |
| obtained in Synthesis Example 8 | Comparative Underlayer film 2 | - | - | - |
| obtained in Synthesis Comparative Example 1 | Comparative Underlayer film 3 | - | - | - |
| obtained in Synthesis Comparative Example 2 | Comparative Underlayer film 4 | 18.1 | 133.7 | 74.1 |
| obtained in Synthesis Comparative Example 3 | Comparative Underlayer film 5 | 15.6 | 132.1 | 71.8 |
| obtained in Synthesis Comparative Example 4 | Comparative Underlayer film 6 | - | - | - |

| | | | | |
|---|---|---|---|---|
| d because of the low solubility in the solvent. | | | | |

From the results of Tables 1 and 2, it was confirmed that the novel underlayer film (of each synthesis example) is capable of improving the solubility and supressing the etching rate.

## Claims

1. An underlayer film material comprising two or more cyclic compounds represented by the following formula (1-1), wherein at least one R' is a group represented by the following formula (1-2), and a content of at least one group represented by the formula (1-2) is 10 mol% to 90 mol% of R' contained in the material: 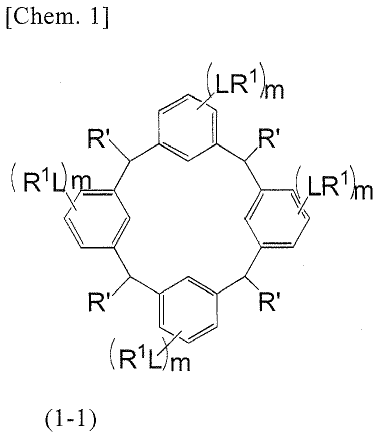 (in the formula (1-1), L is independently a divalent group selected from the group consisting of a single bond, a linear or branched alkylene group having a carbon number of 1 to 20, a cycloalkylene group having a carbon number of 3 to 20, an arylene group having a carbon number of 6 to 24, -O-, -OC(=O)-, -OC(=O)O-, - N(R⁵)-C(=O)-, -N(R⁵)-C(=O)O-, -S-, -SO-, -SO₂-, and any combination thereof; R¹ is independently an alkyl group having a carbon number of 1 to 20, a cycloalkyl group having a carbon number of 3 to 20, an aryl group having a carbon number of 6 to 20, an alkoxyl group having a carbon number of 1 to 20, a cyano group, a nitro group, a hydroxyl group, a heterocyclic group, a halogen atom, a carboxyl group, an acyl group having a carbon number of 2 to 20, an alkylsilyl group having a carbon number of 1 to 20, or a hydrogen atom; R' is independently a hydrogen atom, an alkyl group having a carbon number of 1 to 20, a biphenyl group, a group which is an aryl group having a carbon number of 6 to 20 substituted an alkyl group having a carbon number of 1 to 20 and a halogen atom for hydrogen atoms or which is an alkyl group having a carbon number of 2 to 20 substituted an alkyl group having a carbon number of 1 to 20 for one or more hydrogen atoms, an aryl group having a carbon number of 6 to 20, an alkoxy group having a carbon number of 1 to 20, a cyano group, a nitro group, a heterocyclic group, a halogen atom, a carboxyl group, an acyl group having a carbon number of 2 to 20, a hydroxyl group and an alkylsilyl group having a carbon number of 1 to 20, or a group represented by the following formula (1-2): 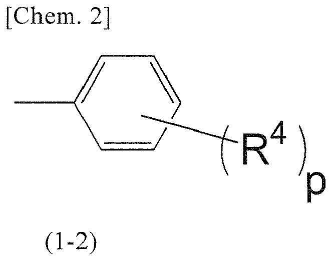 wherein, R⁴ is independently a functional group selected from the group consisting of a hydrogen atom, an alkyl group having a carbon number of 1 to 20, a cycloalkyl group having a carbon number of 3 to 20, an aryl group having a carbon number of 6 to 20, an alkoxy group having a carbon number of 1 to 20, a cyano group, a nitro group, a heterocyclic group, a halogen atom, a carboxyl group, a hydroxyl group, a cycloalkyl group having a alkyl group having a carbon number of 3 to 20, and an alkylsilyl group having a carbon number of 1 to 20; R5 is a hydrogen atom or an alkyl group having a carbon number of 1 to 10; m is an integer of 1 to 4; and, p is an integer of 0 to 5).

2. An underlayer film material according to claim 1, whrerein the cyclic compounds are represented by the following formula (2): 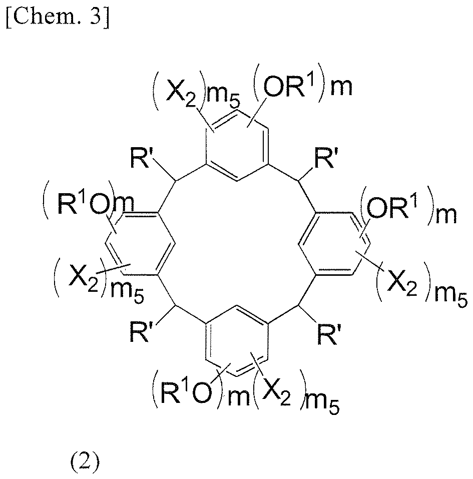 (in the formula (2), R¹, R' and m are the same as described above; X₂ is a hydrogen atom or a halogen atom; m₅ is an integer of 0 to 3; and, m + m₅ = 4).

3. An underlayer film material according to claim 1, wherein the cyclic compounds are represented by the following formula (3): 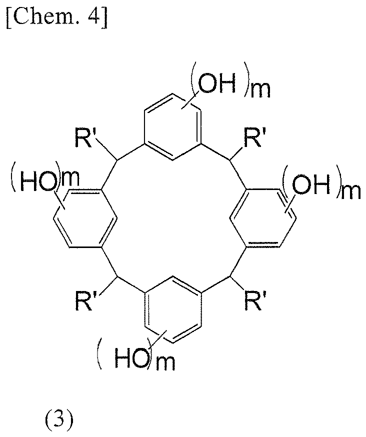 (in the formula (3), R' and m are the same as desdcribed above, with the proviso that all R' are not necessarily identical).

4. An underlayer film material according to claim 1, wherein R' comprises a group selected from the group consisting of groups represented by the following formulae (1-3), and all R' are not identical.

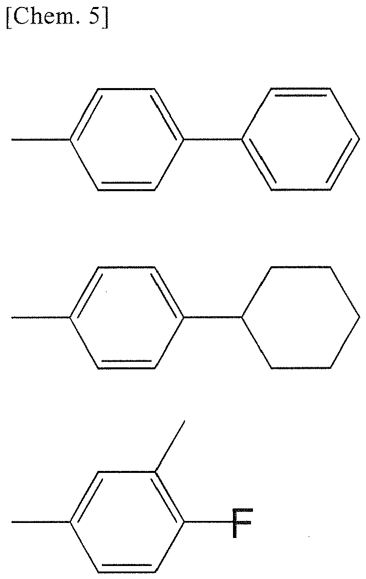

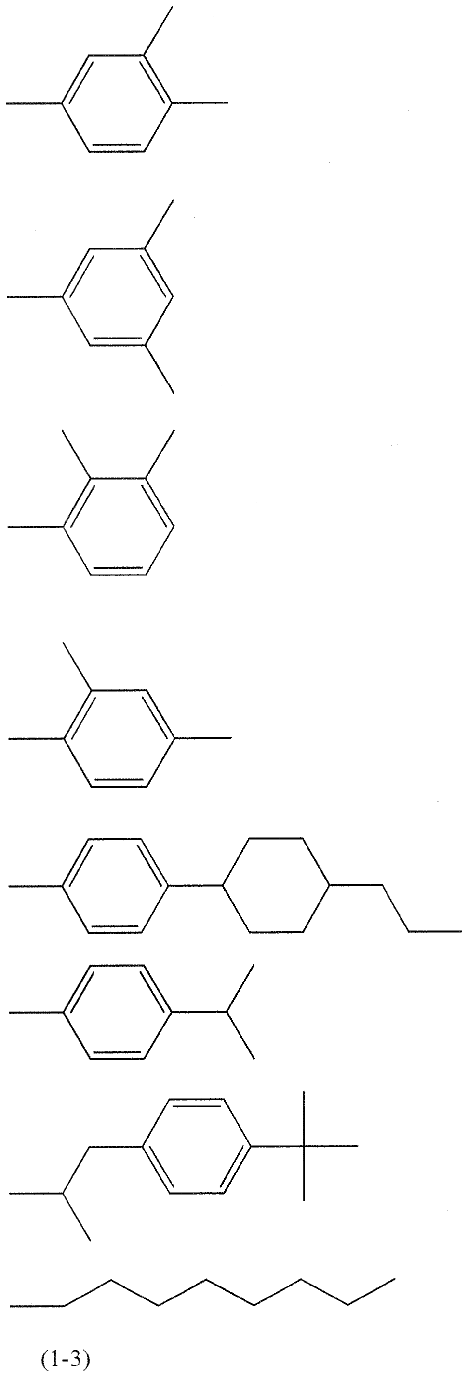

5. An underlayer film material according to claim 1, which is obtained by condensation reacting two or more selected from the group consisting of aldehydes (A1) represented by the following formula (4-1) (with the proviso that at least one is an aldehyde represented by the following formula (4-2)) and one or more selected from the group consisting of phenolic compounds (A2) by using an acid catalyst: 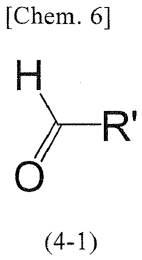 (in the formula (4-1), R' is the same as described above) 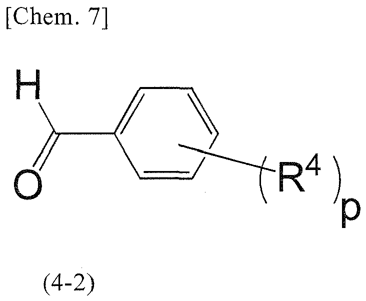 (in the formula (4-2), R⁴ and p are the same as described above).

6. An underlayer film material according to claim 5, which is obtained by dropping a mixed solution (B) consisting of the two or more selected from the group consisting of aldehydes (A1) (with the proviso that at least one is an aldehyde represented by the formula (4-2)) to a mixed solution (A) consisting of the phenolic compound (A2), the acid catalyst and an alcohol.

7. An underlayer film material according to claim 1, which further comprises a solvent.

8. An underlayer film material according to claim 1 or 7, wherein the cyclic compounds are cyclic compounds (A) having a molecular weight of 700 to 5000 and synthesized by condensation reaction of two or more selected from the group consisting of aldehydes (A1) represented by the following formula (4-1) (with the proviso that at least one is an aldehyde represented by the formula (4-2)) and one or more selected from the group consisting of phenolic compounds (A2) by using an acid catalyst: 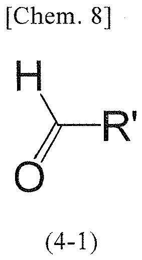 (in the formula (4-1), R' is the same as described above) 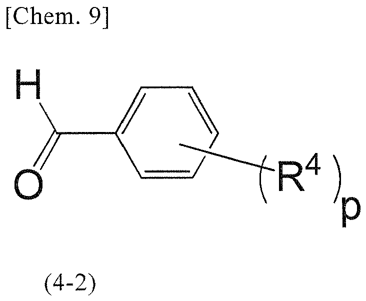 (in the formula (4-2), R⁴ and p are the same as described above).

9. An underlayer film material according to claim 8, which consists of 1 to 80 % by weight of a solid component and 20 to 99 % by weight of a solvent.

10. An underlayer film material according to claim 9, wherein the cyclic compounds (A) are 50 to 99.999 % by weight in the total weight of the solid component.

11. An underlayer film material according to claim 7, which further comprises an acid generator (C) directly or indirectly generating an acid by irradiation any radiation selected from the group consisting of visible light, ultraviolet ray, excimer laser, electron beams, extreme ultraviolet ray (EUV), X-ray and ion beams.

12. An underlayer film material according to claim 7, which further comprises an acid crosslinking agent (G).

13. An underlayer film material according to claim 7, which further comprises an acid-diffusion controller (E).

14. An underlayer film material according to claim 9, wherein the soild component comprises cyclic compound (A)/acid generator (C)/acid crosslinking agent (G)/acid-diffusion controller (E)/optional component (F) of 50-99.489/0.001-49.49/0.5-49.989/0.01-49.499/0-49.489 % by weight based on the solid component.

15. An underlayer film material according to claim 7, which is used in forming an amorphous film with spin coating.

16. An underlayer film formed with an underlayer film material according to any of claims 1 to 15.

17. A method of forming a resist pattern, comprising a step of forming an underlayer film on a substrate with the use of an underlayer film material according to any of claims 1 to 15, a step of exposing the underlayer film to radiation, and a step of developing a resist film made from the underlayer film to form a resist pattern.
